# EUROPEAN PATENT APPLICATION

(11) **EP 4 654 799 A1**
(43) Date of publication of application: **26.11.2025**
(21) Application number: 24830278.8
(22) Date of filing: 20.05.2024
(51) Int. Cl.: H10K 59/35

(54) **DISPLAY SUBSTRATE AND DISPLAY PANEL**

(30) Priority: 29.06.2023 CN 202310788322
(71) Applicant: BOE TECHNOLOGY GROUP CO., LTD., Beijing 100015 (CN); Chongqing Boe Display Technology Co., Ltd., Chongqing 400714 (CN)
(72) Inventor: DENG, Yingxiong, Beijing 100176 (CN); GAO, Dongyu, Beijing 100176 (CN); TONG, Xunfei, Beijing 100176 (CN); NIE, Han, Beijing 100176 (CN); YANG, Chunmei, Beijing 100176 (CN); LV, Tong, Beijing 100176 (CN); DENG, Chengji, Beijing 100176 (CN); ZHAO, Gen, Beijing 100176 (CN); CHEN, Jia, Beijing 100176 (CN); JIANG, Xingzong, Beijing 100176 (CN); HUANG, Jingwei, Beijing 100176 (CN); HE, Liu, Beijing 100176 (CN); DU, Ling, Beijing 100176 (CN)
(74) Representative: Hoffmann Eitle
(86) International application number: PCT/CN2024/094287
(87) International publication number: WO 2025/001630

(57) **Abstract**

Disclosed is a display substrate. The display substrate comprises a plurality of sub-pixels arranged in a plurality of rows and columns; each sub-pixel comprises a light-emitting device; and the light-emitting device comprises a first electrode, a first light-emitting unit, a charge generation laminate, a second light-emitting unit and a second electrode which are sequentially stacked. In a first direction, the colors of light emitted by the light-emitting devices in two adjacent sub-pixels are different, and the proportion of miscellaneous peaks of emission peaks in light-emitting spectra corresponding to the light emitted by the light-emitting devices in at least some of the sub-pixels is less than or equal to 5%.

## Description

This application claims priority to Chinese Patent Application No. 202310788322.6, filed on June 29, 2023, which is incorporated herein by reference in its entirety.

### TECHNICAL FIELD

The present disclosure relates to the field of display technologies, and in particular, to a display substrate and a display panel.

### BACKGROUND

OLED (Organic light-emitting diode) display apparatuses have become one of the most competitive and promising display apparatuses due to their advantages such as self-luminescence, fast response, high brightness, full viewing angle, and flexible display.

### SUMMARY

In an aspect, a display substrate is provided. The display substrate includes a plurality of sub-pixels arranged in a plurality of rows and a plurality of columns, each sub-pixel includes a light-emitting device, and the light-emitting device includes a first electrode, a first light-emitting unit, a charge generation stack layer, a second light-emitting unit, and a second electrode that are stacked in sequence. Light-emitting devices in two adjacent sub-pixels in a first direction emit light of different colors; and a proportion of undesired peaks in an emission peak in a luminescence spectrum corresponding to light emitted by a light-emitting device in at least part of the sub-pixels is less than or equal to 5%.

In some embodiments, in a case where a grayscale of the light-emitting device in the sub-pixel is higher than a threshold grayscale, the proportion of the undesired peaks in the emission peak in the luminescence spectrum corresponding to the light emitted by the light-emitting device in the at least part of the sub-pixels is approximately 0%. In a case where the grayscale of the light-emitting device in the sub-pixel is lower than the threshold grayscale, the proportion of the undesired peaks in the emission peak in the luminescence spectrum corresponding to the light emitted by the light-emitting device in the at least part of the sub-pixels is less than or equal to 4%.

In some embodiments, a lateral resistance of the charge generation stack layer is greater than or equal to 100 GΩ/µm2.

In some embodiments, the lateral resistance of the charge generation stack layer is less than or equal to 260 GΩ/µm2.

In some embodiments, the charge generation stack layer includes an n-type charge generation layer and a p-type charge generation layer; the p-type charge generation layer is located on a side of the n-type charge generation layer away from the first electrode. The charge generation stack layer is configured such that the n-type charge generation layer transports electrons to the first light-emitting unit and the p-type charge generation layer transports holes to the second light-emitting unit.

In some embodiments, a minimum distance between a surface of the n-type charge generation layer close to the p-type charge generation layer and the first light-emitting unit is less than a minimum distance between a surface of the first electrode away from the first light-emitting unit and the first light-emitting unit.

In some embodiments, a thickness of the n-type charge generation layer is in a range of 50 Å to 250 Å.

In some embodiments, the thickness of the n-type charge generation layer is in a range of 50 Å to 70 Å.

In some embodiments, the n-type charge generation layer is doped with a first foreign substance, and a doping concentration of the first foreign substance in the n-type charge generation layer is in a range of 0.5% to 2%.

In some embodiments, the p-type charge generation layer is doped with a second foreign substance, and a doping concentration of the second foreign substance in the p-type charge generation layer is in a range of 5% to 15%.

In some embodiments, in a case where the doping concentration of the first foreign substance in the n-type charge generation layer is in a range of 0.5% to 1%, the doping concentration of the second foreign substance in the p-type charge generation layer is in a range of 10% to 15%. Alternatively, in a case where the doping concentration of the first foreign substance in the n-type charge generation layer is in a range of 1% to 2%, the doping concentration of the second foreign substance in the p-type charge generation layer is in a range of 5% to 10%.

In some embodiments, in a case where a lateral resistance of the charge generation stack layer is in a range of 180 GΩ/µm2 to 260 GΩ/µm2, a doping concentration of a second foreign substance in the p-type charge generation layer is in a range of 5% to 10%. Alternatively, in a case where the lateral resistance of the charge generation stack layer is in a range of 100 GΩ/µm2 to 180 GΩ/µm2, the doping concentration of the second foreign substance in the p-type charge generation layer is in a range of 10% to 15%.

In some embodiments, a minimum distance between the two adjacent sub-pixels in the first direction is greater than or equal to 19 µm.

In some embodiments, the minimum distance between the two adjacent sub-pixels in the first direction is less than or equal to 24 µm.

In some embodiments, a thickness of the p-type charge generation layer is in a range of 350 Å to 700 Å.

In some embodiments, the light-emitting device further includes a hole transport layer and an electron transport layer. The hole transport layer is located between the first electrode and the first light-emitting unit, and the electron transport layer is located between the second electrode and the second light-emitting unit.

In some embodiments, the light-emitting device further includes a first hole blocking layer and a second hole blocking layer. The first hole blocking layer is located between the first light-emitting unit and the charge generation stack layer, and the second hole blocking layer is located between the electron transport layer and the second light-emitting unit.

In some embodiments, the plurality of sub-pixels include: a plurality of first sub-pixels, a plurality of second sub-pixels, and a plurality of third sub-pixels, which emit light of different colors. The third sub-pixels are blue sub-pixels; and a size of a blue sub-pixel is greater than a size of any sub-pixel among the plurality of first sub-pixels and the plurality of second sub-pixels.

In another aspect, a display panel is provided. The display panel includes the display substrate as described in any of the above embodiments.

### BRIEF DESCRIPTION OF THE DRAWINGS

In order to describe technical solutions in some embodiments of the present disclosure more clearly, the accompanying drawings to be used in some embodiments of the present disclosure will be introduced briefly; obviously, the accompanying drawings to be described below are merely some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display apparatus, in accordance with some embodiments;
FIG. 2 is a structural diagram of a display panel, in accordance with some embodiments;
FIG. 3 is a sectional view taken along the line B-B' in FIG. 2;
FIG. 4 is a structural diagram of a light-emitting device, in accordance with some embodiments;
FIG. 5 is a spectrum diagram of a light-emitting device for emitting red light, in accordance with some possible implementations;
FIG. 6 is a spectrum diagram of a light-emitting device for emitting green light, in accordance with some possible implementations;
FIG. 7 is a spectrum diagram of a light-emitting device for emitting blue light, in accordance with some possible implementations;
FIG. 8 is a spectrum diagram of a light-emitting device for emitting red light, in accordance with some other possible implementations;
FIG. 9 is a spectrum diagram of a light-emitting device for emitting green light, in accordance with some other possible implementations;
FIG. 10 is a spectrum diagram of a light-emitting device for emitting blue light, in accordance with some other possible implementations;
FIG. 11 is a spectrum diagram of a light-emitting device for emitting red light, in accordance with some embodiments;
FIG. 12 is a spectrum diagram of a light-emitting device for emitting green light, in accordance with some embodiments;
FIG. 13 is a spectrum diagram of a light-emitting device for emitting blue light, in accordance with some embodiments;
FIG. 14 is a structural diagram of a light-emitting device, in accordance with some other embodiments;
FIG. 15 is a spectrum diagram of a light-emitting device for emitting red light, in accordance with some other embodiments;
FIG. 16 is a spectrum diagram of a light-emitting device for emitting green light, in accordance with some other embodiments;
FIG. 17 is a spectrum diagram of a light-emitting device for emitting blue light, in accordance with some other embodiments;
FIG. 18 is a spectrum diagram of a light-emitting device for emitting red light, in accordance with yet some other embodiments;
FIG. 19 is a spectrum diagram of a light-emitting device for emitting green light, in accordance with yet some other embodiments;
FIG. 20 is a spectrum diagram of a light-emitting device for emitting blue light, in accordance with yet some other embodiments;
FIG. 21 is a spectrum diagram of a light-emitting device for emitting red light, in accordance with yet some other embodiments;
FIG. 22 is a spectrum diagram of a light-emitting device for emitting green light, in accordance with yet some other embodiments;
FIG. 23 is a spectrum diagram of a light-emitting device for emitting blue light, in accordance with yet some other embodiments;
FIG. 24 is a spectrum diagram of a light-emitting device for emitting red light, in accordance with yet some other embodiments;
FIG. 25 is a spectrum diagram of a light-emitting device for emitting green light, in accordance with yet some other embodiments;
FIG. 26 is a spectrum diagram of a light-emitting device for emitting blue light, in accordance with yet some other embodiments;
FIG. 27 is a spectrum diagram of a light-emitting device for emitting red light, in accordance with yet some other embodiments;
FIG. 28 is a spectrum diagram of a light-emitting device for emitting green light, in accordance with yet some other embodiments;
FIG. 29 is a spectrum diagram of a light-emitting device for emitting blue light, in accordance with yet some other embodiments;
FIG. 30 is a spectrum diagram of a light-emitting device for emitting red light, in accordance with yet some other embodiments;
FIG. 31 is a spectrum diagram of a light-emitting device for emitting green light, in accordance with yet some other embodiments;
FIG. 32 is a spectrum diagram of a light-emitting device for emitting blue light, in accordance with yet some other embodiments;
FIG. 33 is a spectrum diagram of a light-emitting device for emitting red light, in accordance with yet some other embodiments;
FIG. 34 is a spectrum diagram of a light-emitting device for emitting green light, in accordance with yet some other embodiments;
FIG. 35 is a spectrum diagram of a light-emitting device for emitting blue light, in accordance with yet some other embodiments;
FIG. 36 is a spectrum diagram of a light-emitting device for emitting red light, in accordance with yet some other embodiments;
FIG. 37 is a spectrum diagram of a light-emitting device for emitting green light, in accordance with yet some other embodiments;
FIG. 38 is a spectrum diagram of a light-emitting device for emitting blue light, in accordance with yet some other embodiments;
FIG. 39 is a spectrum diagram of a light-emitting device for emitting red light, in accordance with yet some other embodiments;
FIG. 40 is a spectrum diagram of a light-emitting device for emitting green light, in accordance with yet some other embodiments;
FIG. 41 is a spectrum diagram of a light-emitting device for emitting blue light, in accordance with yet some other embodiments;
FIG. 42 is a spectrum diagram of a light-emitting device for emitting red light, in accordance with yet some other embodiments;
FIG. 43 is a spectrum diagram of a light-emitting device for emitting green light, in accordance with yet some other embodiments;
FIG. 44 is a spectrum diagram of a light-emitting device for emitting blue light, in accordance with yet some other embodiments;
FIG. 45 is a spectrum diagram of a light-emitting device for emitting red light, in accordance with yet some other embodiments;
FIG. 46 is a spectrum diagram of a light-emitting device for emitting green light, in accordance with yet some other embodiments;
FIG. 47 is a spectrum diagram of a light-emitting device for emitting blue light, in accordance with yet some other embodiments;
FIG. 48 is a spectrum diagram of a light-emitting device for emitting red light, in accordance with yet some other embodiments;
FIG. 49 is a spectrum diagram of a light-emitting device for emitting green light, in accordance with yet some other embodiments;
FIG. 50 is a spectrum diagram of a light-emitting device for emitting blue light, in accordance with yet some other embodiments;
FIG. 51 is a spectrum diagram of a light-emitting device for emitting red light, in accordance with yet some other embodiments;
FIG. 52 is a spectrum diagram of a light-emitting device for emitting green light, in accordance with yet some other embodiments;
FIG. 53 is a spectrum diagram of a light-emitting device for emitting blue light, in accordance with yet some other embodiments;
FIG. 54 is a spectrum diagram of a light-emitting device for emitting red light, in accordance with yet some other embodiments;
FIG. 55 is a spectrum diagram of a light-emitting device for emitting green light, in accordance with yet some other embodiments;
FIG. 56 is a spectrum diagram of a light-emitting device for emitting blue light, in accordance with yet some other embodiments;
FIG. 57 is a structural diagram of a display substrate, in accordance with some other embodiments;
FIG. 58 is a spectrum diagram of a light-emitting device for emitting red light, in accordance with yet some other embodiments;
FIG. 59 is a spectrum diagram of a light-emitting device for emitting green light, in accordance with yet some other embodiments;
FIG. 60 is a spectrum diagram of a light-emitting device for emitting blue light, in accordance with yet some other embodiments;
FIG. 61 is a spectrum diagram of a light-emitting device for emitting red light, in accordance with yet some other embodiments;
FIG. 62 is a spectrum diagram of a light-emitting device for emitting green light, in accordance with yet some other embodiments;
FIG. 63 is a spectrum diagram of a light-emitting device for emitting blue light, in accordance with yet some other embodiments;
FIG. 64 is a structural diagram of a light-emitting device, in accordance with yet some other embodiments; and
FIG. 65 is a structural diagram of a light-emitting device, in accordance with yet some other embodiments.

### DETAILED DESCRIPTION

The technical solutions in some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

The terms "first" and "second" are used for descriptive purposes only, and are not to be construed as indicating or implying a relative importance or implicitly indicating the number of indicated technical features. Thus, features defined with "first" or "second" may explicitly or implicitly include one or more of the features. In the description of the embodiments of the present disclosure, the term "multiple", "a plurality of" or "the plurality of" means two or more unless otherwise specified.

In the description of some embodiments, the expressions "coupled," "connected," and derivatives thereof may be used. The term "connected" should be understood in a broad sense. For example, the term "connected" may represent a fixed connection, a detachable connection, or a one-piece connection, or may represent a direct connection, or may represent an indirect connection through an intermediate medium. The term "coupled" indicates that two or more components are in direct physical or electrical contact with each other. The term "coupled" or "communicatively coupled" may also indicate that two or more components are not in direct contact with each other, but still cooperate or interact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

As used herein, the term "if" is optionally construed as "when" or "in a case where" or "in response to determining" or "in response to detecting", depending on the context. Similarly, depending on the context, the phrase "if it is determined that" or "if [a stated condition or event] is detected" is optionally construed as "in a case where it is determined that", "in response to determining that", "in a case where [the stated condition or event] is detected" or "in response to detecting [the stated condition or event]".

The phrase "applicable to" or "configured to" used herein has an open and inclusive meaning, which does not exclude devices that are applicable to or configured to perform additional tasks or steps.

In addition, the phrase "based on" used is meant to be open and inclusive, since a process, step, calculation or other action that is "based on" one or more of the stated conditions or values may, in practice, be based on additional conditions or value exceeding those stated.

The term such as "about," "substantially," or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel," "perpendicular," or "equal" as used herein includes a stated condition and a condition similar to the stated condition. A range of the similar condition is within an acceptable deviation range, and the acceptable deviation range is determined by a person of ordinary skill in the art, considering measurement in question and errors associated with measurement of a particular quantity (i.e., the limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be that, for example, a difference between the two that are equal is less than or equal to 5% of either of the two.

It will be understood that, when a layer or element is referred to as being on another layer or substrate, it may be that the layer or element is directly on the another layer or substrate, or it may be that intermediate layer(s) exist between the layer or element and the another layer or substrate.

Exemplary embodiments are described herein with reference to sectional views and/or plan views that are schematic illustrations of idealized embodiments. In the drawings, thicknesses of layers and areas of regions are enlarged for clarity. Variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Thus, the regions shown in the accompanying drawings are schematic in nature, and their shapes are not intended to show actual shapes of the regions in a device, and are not intended to limit the scope of the exemplary embodiments.

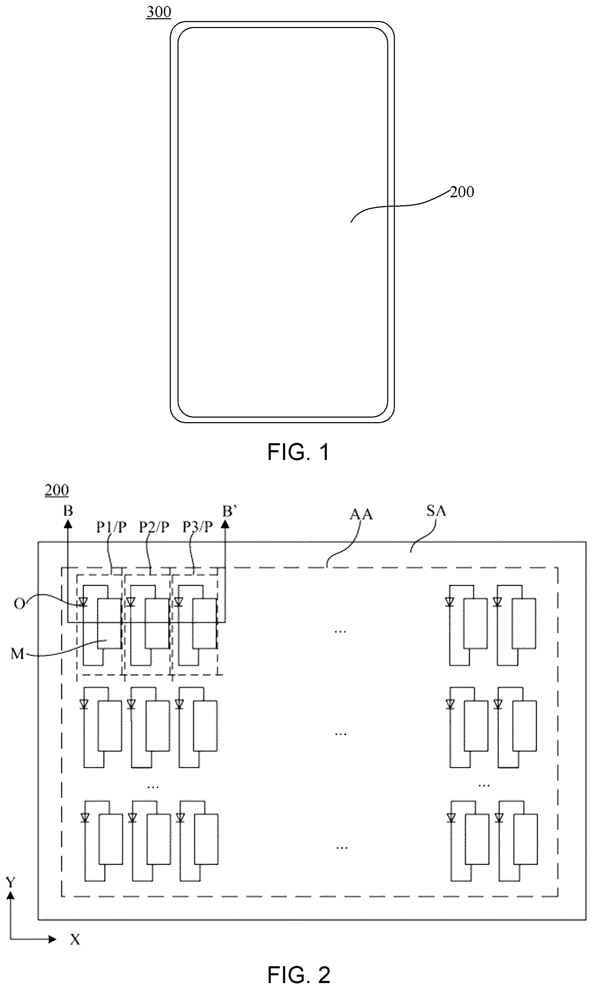

FIG. 1 is a structural diagram of a display apparatus, in accordance with some embodiments. Referring to FIG. 1, some embodiments of the present disclosure provide a display apparatus 300, and the display apparatus 300 includes a display panel 200.

For example, the display apparatus 300 further includes a frame, a display driver integrated circuit (IC) and other electronic components.

In addition, the display apparatus 300 may further include an under-screen camera and an under-screen fingerprint recognition sensor, so that the display apparatus can realize various functions such as photographing, video recording, fingerprint recognition or face recognition.

For example, the display apparatus 300 may be an electroluminescent display apparatus. For example, the display apparatus 300 may be an organic electroluminescent display apparatus (organic light-emitting diode (OLED) display apparatus) or a quantum electroluminescent display apparatus (quantum dot light-emitting diode (QLEO) display apparatus).

In the case where the display apparatus is the organic electroluminescent display apparatus, the display panel 200 may be an organic electroluminescent display panel. In the case where the display apparatus 300 is the quantum electroluminescent display apparatus, the display panel 200 may be a quantum dot electroluminescent display panel.

For example, the display apparatus 300 may be any apparatus that displays images whether in motion (e.g., videos) or stationary (e.g., static images), and whether textual or graphical. More specifically, it is expected that the display apparatus in the embodiments may be implemented in or associated with a plurality of electronic devices. The plurality of electronic devices may include (but are not limit to), for example, mobile telephones, wireless devices, personal digital assistants (PDAs), hand-held or portable computers, GPS receivers/navigators, cameras, MP4 video players, video cameras, game consoles, watches, clocks, calculators, TV monitors, flat panel displays, computer monitors, car displays (such as odometer displays), navigators, cockpit controllers and/or displays, camera view displays (such as rear view camera displays in vehicles), electronic photos, electronic billboards or indicators, projectors, building structures, packagings and aesthetic structures (such as a display for an image of a piece of jewelry), etc.

Next, the OLED display apparatus and its corresponding OLED display panel will be taken as an example for description.

FIG. 2 is a structural diagram of a display panel, in accordance with some embodiments.

Referring to FIG. 2, some embodiments of the present disclosure provide a display panel 200. The display panel 200 has a display region AA and a peripheral region SA. The peripheral region SA may be located on at least one side (e.g., one side; or four sides which include upper and lower sides and left and right sides) of the display region AA.

The display panel 200 includes a plurality of sub-pixels P disposed in the display region AA. Due to light emitted by the plurality of sub-pixels P, the display panel 200 may display a predetermined image in the display region AA. Specifically, the plurality of sub-pixels P may include sub-pixels emitting light of different colors.

For convenience of the description, herein, the plurality of sub-pixels P are described by considering an example in which the plurality of sub-pixels P are arranged in an array. In this case, sub-pixels P arranged in a line in a first direction X are referred to as sub-pixels in a same row, and sub-pixels P arranged in a line in a second direction Y are referred to as sub-pixels in a same column.

The first direction X and the second direction Y intersect. The first direction X and the second direction Y intersect with each other, and an included angle between the first direction X and the second direction Y may be set according to actual needs. For example, the included angle between the first direction X and the second direction Y may be 85°, 89° or 90°.

For example, the plurality of sub-pixels P include first sub-pixels P1, second sub-pixels P2 and third sub-pixels P3. Colors of light emitted by the first sub-pixels P1, the second sub-pixels P2 and the third sub-pixels P3 are three primary colors. For example, the first sub-pixels P1 may emit red light, the second sub-pixels P2 may emit green light, and the third sub-pixels P3 may emit blue light.

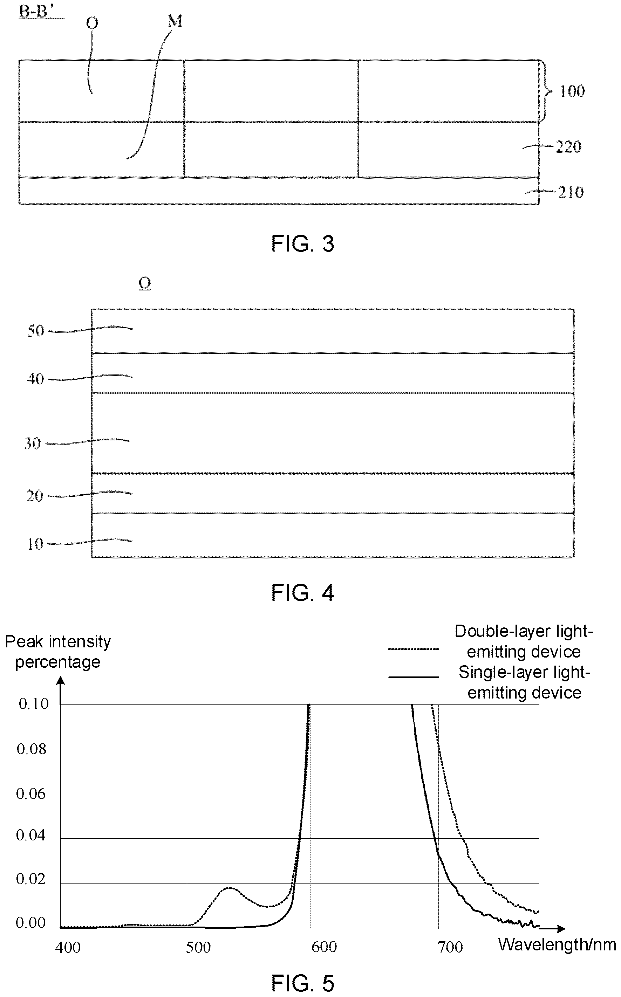

FIG. 3 is a sectional view taken along the line B-B' in FIG. 2.

Referring to FIGS. 2 and 3, the display panel 200 further includes a plurality of film layers. The plurality of film layers in the display panel 200 will be introduced below.

In some embodiments, the plurality of film layers in the display panel 200 include a display substrate 100, and the display substrate 100 includes a plurality of light-emitting devices O. The plurality of light-emitting devices O in the display substrate 100 are used to emit light so that the display panel 200 displays images. The display panel 200 may be the display panel 200 in the display apparatus 300 as mentioned above.

For example, the light-emitting device O may be an organic light-emitting diode (OLED) or a quantum dot light-emitting diode (QLED). The following description will be made by taking an example in which the light-emitting device O may be an OLED.

In some embodiments, the plurality of film layers in the display panel 200 further include a substrate 210, and a pixel circuit layer 220 and the display substrate 100 located on the substrate. The display substrate 100 is located on a side of the pixel circuit layer 220 away from the substrate 210.

In some examples, the substrate 210 may be a flexible substrate. For example, the substrate 210 may be made of an organic material. For example, the substrate 210 may be made of any one of polyimide (PI), polycarbonate (PC) or polyvinyl chloride (PVC).

In some other examples, the substrate 210 may be a rigid substrate. For example, the rigid substrate may be a glass substrate or a polymethyl methacrylate (PMMA) substrate.

In some examples, the pixel circuit layer 220 includes a plurality of pixel driving circuits M, and the pixel driving circuit M includes a plurality of transistors. In some examples, a structure of the pixel driving circuit in the present disclosure varies, which may be set according to actual needs. For example, the structure of the pixel driving circuit P1 may include a structure of "2T1C", "6T1C", "7T1C", "6T2C", "7T2C" or "8T1C". Here, "T" represents a thin film transistor, a number before "T" represents the number of thin film transistors, "C" represents a storage capacitor, and a number before "C" represents the number of storage capacitors. The following description will be made by taking the pixel driving circuit M of the "7T1C" structure as an example.

No matter what structure the pixel driving circuit M has, the pixel driving circuit M needs to be electrically connected to a light-emitting device O (an anode of the light-emitting device O) in the display substrate 100. Therefore, the pixel driving circuit M in the pixel circuit layer 220 controls the light-emitting device O in the display substrate 100 to emit light. As a result, the display panel 200 can display images.

In some examples, in the display panel 200, the plurality of pixel driving circuits M and the plurality of light-emitting devices O may be electrically connected in one-to-one correspondence. In some other examples, a single pixel driving circuit M may be electrically connected to multiple light-emitting devices O, or multiple pixel driving circuits M may be electrically connected to a single light-emitting device O.

In the present disclosure, the structure of the display panel 200 will be introduced below by taking an example in which a single pixel driving circuit M is electrically connected to a single light-emitting device O.

Based on this, for a single sub-pixel P: the sub-pixel P may include a light-emitting device O that is located in the display substrate 100 and a pixel driving circuit M that is located in the pixel circuit layer 220 and electrically connected to the light-emitting device O.

The film layer structure of the display panel 200 is described above with reference to relevant accompanying drawings. Next, the structure of the display substrate 100 in the display panel 200 will be described with reference to relevant accompanying drawings.

With continued reference to FIG. 3, some embodiments of the present disclosure provide a display substrate 100. In this case, the display substrate 100 may be the display substrate as mentioned above.

The display substrate 100 includes a plurality of sub-pixels P arranged in a plurality of rows and a plurality of columns. The sub-pixels P in the display substrate 100 correspond to the sub-pixels P in the display panel 200 as mentioned above, which will not be repeated here.

It will be noted that, since this embodiment mainly introduces the structure of the display substrate 100, the pixel circuit layer is not involved. That is, in this case, the sub-pixel P includes only the light-emitting device O in the display substrate 100.

FIG. 4 is a structural diagram of a light-emitting device, in accordance with some embodiments.

Referring to FIG. 4, with the continuous development of display technologies, people have higher and higher requirements on display quality. In order to further reduce power consumption and achieve high brightness, a single light-emitting layer in the light-emitting device O may be replaced with two light-emitting layers, and a charge generation stack layer (charge generation layer (CGL)) 30 is added between the two light-emitting layers to realize a double-layer luminescence (Tandem EL) design. Specifically, the two light-emitting layers (a first light-emitting unit 20 and a second light-emitting unit 40) are connected in series using the charge generation stack layer 30, so as to form a light-emitting device O of the Tandem EL design.

However, the inventors of the present disclosure have found through research that, the charge generation stack layer 30 has strong conductivity; in adjacent sub-pixels P, first light-emitting units 20 are connected, charge generation stack layers 30 are connected, and second light-emitting units 40 are connected; therefore, the charge generation stack layers 30 easily cause crosstalk between two adjacent sub-pixels P. As a result, the display quality is seriously affected.

Specifically, since an interval between charge generation stack layers 30 of two adjacent sub-pixels P in a direction of a connection line of the charge generation stack layers 30 is small and the resistance of the charge generation stack layer 30 in an extending direction of the connection line is also small, carriers in the charge generation stack layer 30 are easily transported from one of the two adjacent sub-pixels P to the other of the two adjacent sub-pixels P through the charge generation stack layers 30 along the extending direction of the connection line. Therefore, the charge generation stack layers 30 easily cause crosstalk between two adjacent sub-pixels P, which results in color shift and in turn seriously affects the display quality.

Since the crosstalk problem of the light-emitting device O in a low grayscale state is more serious than the crosstalk problem of the light-emitting device O in a high grayscale state, the description is made by taking an example in which the grayscale of the light-emitting device O in the display substrate 100 is a high grayscale (for example, 255 grayscale).

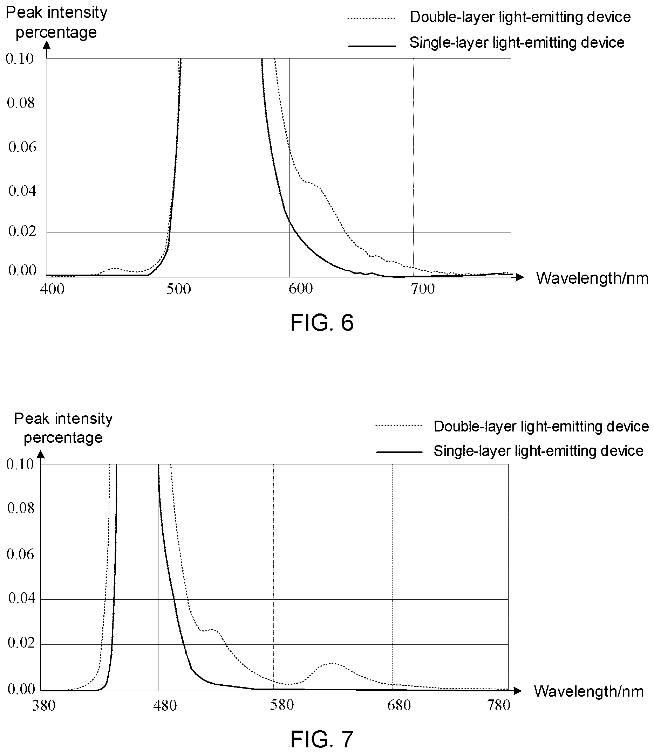

FIG. 5 is a spectrum diagram of a light-emitting device for emitting red light, in accordance with some possible implementations. FIG. 6 is a spectrum diagram of a light-emitting device for emitting green light, in accordance with some possible implementations. FIG. 7 is a spectrum diagram of a light-emitting device for emitting blue light, in accordance with some possible implementations.

A light-emitting device O shown in FIG. 5 may be a first light-emitting device O1, and the first light-emitting device O1 is located in the first sub-pixel P1. A light-emitting device O shown in FIG. 6 may be a second light-emitting device O2, and the second light-emitting device O2 is located in the second sub-pixel P2. A light-emitting device O shown in FIG. 7 may be a third light-emitting device O3, and the third light-emitting device O3 is located in the third sub-pixel P3.

With reference to FIGS. 5 to 7, it can be clearly seen that the spectrum of the double-layer light-emitting device (the light-emitting device O of the Tandem EL design) emitting color light have many undesired peaks compared to the spectrum of the single-layer light-emitting device (including only one light-emitting unit). That is, since the charge generation stack layer 30 easily causes crosstalk between two adjacent sub-pixels P, when a light-emitting device O of one color in the display substrate 100 is turned on, light-emitting devices O of two adjacent sub-pixels P will be mistakenly turned on due to the crosstalk, and undesired peaks of other color light emission will be clearly observed in a spectrum corresponding to the light-emitting device O, which results in insufficient color gamut and impure color of the light-emitting device O, which in turn seriously affects the display quality.

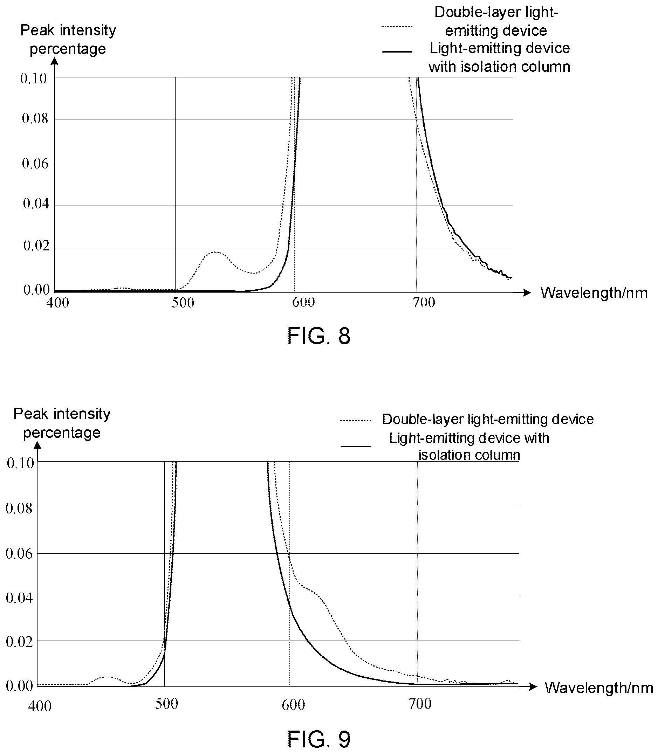

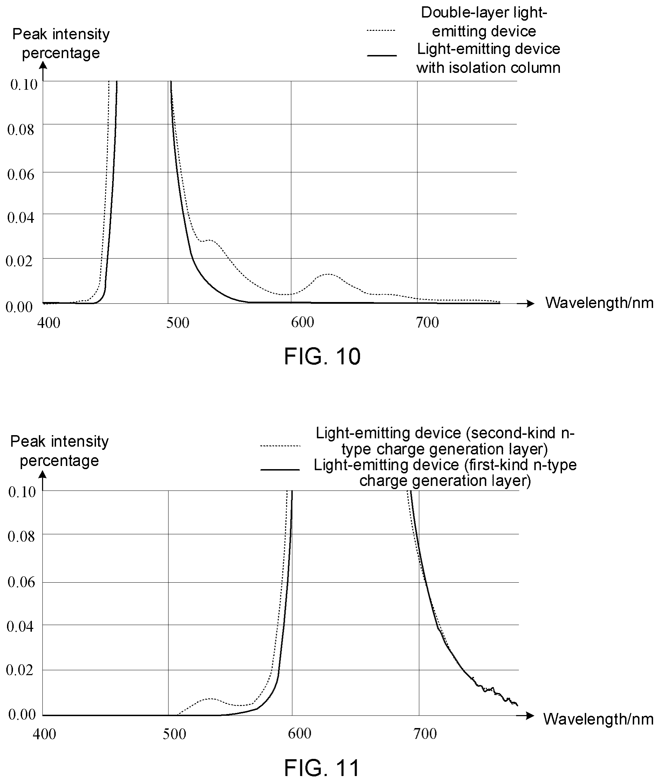

In some possible implementations, FIG. 8 is a spectrum diagram of a light-emitting device for emitting red light, in accordance with some other possible implementations; FIG. 9 is a spectrum diagram of a light-emitting device for emitting green light, in accordance with some other possible implementations; and FIG. 10 is a spectrum diagram of a light-emitting device for emitting blue light, in accordance with some other possible implementations.

With reference to FIGS. 8 to 10, an isolation column is provided between the charge generation stack layers 30 of two adjacent sub-pixels P. That is, the charge generation stack layers 30 of the two adjacent sub-pixels P are disconnected, and the isolation column is arranged between the charge generation stack layers 30 of the two sub-pixels P. The isolation column effectively prevents lateral crosstalk of carriers in the charge generation stack layers 30 between the two sub-pixels P, thereby reducing undesired peaks in the spectrum diagram of each light-emitting device O, mitigating the color cast of the display substrate 100, and improving the display quality.

However, the inventors of the present disclosure have found through research that although providing the isolation column(s) in the display substrate 100 may facilitate mitigation of the lateral crosstalk of carriers in the charge generation stack layers 30 in the light-emitting devices O and improvement of the display quality, adding isolation column(s) in the display substrate 100 will also cause corresponding problems. For example, adding the isolation column(s) requires an additional patterning process during the process of manufacturing the display substrate 100, such that the support of the display substrate 100 will be affected, and the cost will be increased. Furthermore, adding the isolation column(s) will increase the resistance of the display substrate 100 and the power consumption of the light-emitting devices O, which is not conducive to realizing the display substrate 100 with low power consumption.

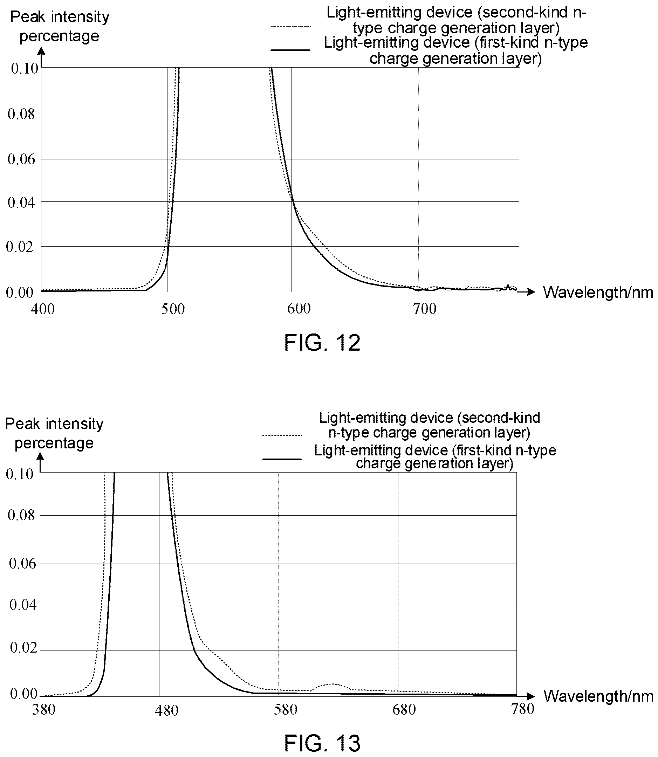

FIG. 11 is a spectrum diagram of a light-emitting device for emitting red light, in accordance with some embodiments. FIG. 12 is a spectrum diagram of a light-emitting device for emitting green light, in accordance with some embodiments. FIG. 13 is a spectrum diagram of a light-emitting device for emitting blue light, in accordance with some embodiments.

The existing double-layer light-emitting devices in FIGS. 11 to 13 are light-emitting devices in the above-mentioned implementations, and the light-emitting devices in FIGS. 11 to 13 are light-emitting devices provided in some embodiments of the present disclosure. The description is made by taking an example in which the grayscale of the light-emitting device O in the display substrate 100 is a high grayscale (e.g., 255 grayscale).

In view of the above problems, some embodiments of the present disclosure provide a display substrate 100. With reference to FIGS. 4, and 11 to 13, the display substrate 100 includes a plurality of sub-pixels P arranged in a plurality of rows and a plurality of columns, and the sub-pixel P includes a light-emitting device O. Light-emitting devices O in two adjacent sub-pixels P in the first direction X emit light of different colors, and a proportion of undesired peaks in an emission peak in the luminescence spectrum corresponding to light emitted by a light-emitting device O in any sub-pixel P is less than or equal to 5%.

Hereinafter, the light-emitting device O of the Tandem EL design will be firstly described in detail.

Referring to FIG. 4, the light-emitting device O includes a first electrode 10, a first light-emitting unit 20, a charge generation stack layer 30, a second light-emitting unit 40, and a second electrode 50, which are stacked in sequence. The first light-emitting unit 20 and the second light-emitting unit 40 are stacked; the charge generation stack layer 30 is added between the first light-emitting unit 20 and the second light-emitting unit 40, which is used as a second electrode corresponding to the first light-emitting unit 20 and a first electrode corresponding to the second light-emitting unit 40; therefore, the light-emitting device O of the Tandem EL design is formed.

Based on this, the first electrode 10, the first light-emitting unit 20 and the charge generation stack layer 30 may constitute an independent and complete light-emitting element, and the charge generation stack layer 30, the second light-emitting unit 40 and the second electrode 50 may constitute an independent and complete light-emitting element. That is, the first electrode 10, the first light-emitting unit 20, the charge generation stack layer 30, the second light-emitting unit 40, and the second electrode 50, which are stacked in sequence, may constitute the light-emitting device O having two independent and complete light-emitting units.

One of the first electrode 10 and the second electrode 50 may be an anode of the light-emitting device O, and another of the first electrode 10 and the second electrode 50 may be a cathode of the light-emitting device O.

The following description will be made by taking an example in which the first electrode 10 is the anode of the light-emitting device O and the second electrode 50 is the cathode of the light-emitting device O.

In some examples, the first electrode 10 may be the anode of the light-emitting device O. In this case, carriers provided by the first electrode 10 may be holes. The first electrode 10 may be made of a metal material, e.g., any one or more of magnesium (Mg), silver (Ag), copper (Cu), aluminum (Al), titanium (Ti) and molybdenum (Mo), or an alloy material of the above metals, such as aluminum neodymium alloy (AlNd) or molybdenum niobium alloy (MoNb); the first electrode 10 may be of a single-layer structure, or a multi-layer composite structure (such as Ti/Al/Ti), or a stack structure formed by metal and transparent conductive material (such as ITO/Ag/ITO, Mo/AlNd/ITO and other reflective materials). However, the embodiments of the present disclosure are not limited thereto.

In some examples, the second electrode 50 is the cathode of the light-emitting device O. In this case, carriers provided by the second electrode 50 may be electrons. The second electrode 50 may be made of any one or more of magnesium (Mg), silver (Ag), aluminum (Al), or an alloy that is made of any one or more of the above metals, or a transparent conductive material (such as indium tin oxide (ITO)), or a multi-layer composite structure of metal and transparent conductive material.

In some other examples, the second electrode 50 of a double-layer composite structure is taken as an example for introduction. The second electrode 50 includes a first metal layer and a second metal layer. The first metal layer may be located on a side of the second metal layer away from the first electrode 10. That is, the second metal layer is located on a side of the first metal layer close to the second light-emitting unit 40. A material of the first metal layer may include two metal materials: magnesium (Mg) and silver (Ag). The second metal layer may be made of ytterbium (Yb). Since the second metal layer is disposed on the side of the first metal layer close to the second light-emitting unit 40, the second metal layer may be used to reduce the potential barrier between the first metal layer and the second light-emitting unit 40, which facilitates the transport of electrons provided by the second electrode 50 to the second light-emitting unit 40.

For example, a ratio of mass of magnesium (Mg) to mass of silver (Ag) in the first metal layer is in a range of 1:9 to 1:20.

For example, a thickness of the second electrode 50 is in a range of 147 A to 165 Å.

For example, a thickness of the first metal layer is in a range of 140 Å to 150 Å.

For example, a thickness of the second metal layer is in a range of 7 Å to 15 Å.

Based on this, the above-mentioned limitations on the material, thickness and other conditions of the metal layers in the second electrode 50 may result in good conductive properties of the second electrode 50. However, the embodiments of the present disclosure are not limited thereto.

For a single light-emitting device O, the first light-emitting unit 20 and the second light-emitting unit 40 emit light of the same color. Considering an example in which the light-emitting device O emits red light, the first light-emitting unit 20 and the second light-emitting unit 40 both emit red light.

The charge generation stack layer 30 is configured to, due to an electric field of the first electrode 10 and the second electrode 50, generate carriers, transport the carriers and inject the carriers. The carriers may include electrons and holes. For example, due to the electric field of the first electrode 10 and the second electrode 50, the charge generation stack layer 30 generates holes moving toward the second electrode 50 and electrons moving toward the first electrode 10.

For example, voltages are applied to the first electrode 10 and the second electrode 50, and the electric field is created between the first electrode 10 and the second electrode 50. Due to the electric field of the first electrode 10 and the second electrode 50, the first electrode 10 generates holes approaching the first light-emitting unit 20, the second electrode 50 generates electrons approaching the second light-emitting unit 40, and the charge generation stack layer 30 generates electrons approaching the first light-emitting unit 20 and holes approaching the second light-emitting unit 40.

Based on this, the electrons generated by the charge generation stack layer 30 and the holes generated by the first electrode 10 will move to the first light-emitting unit 20 and recombine into excitons in the first light-emitting unit 20, so that the first light-emitting unit 20 emits light. The holes generated by the charge generation stack layer 30 and the electrons generated by the second electrode 50 move to the second light-emitting unit 40 and recombine into excitons in the second light-emitting unit 40, so that the second light-emitting unit 40 emits light. Thereby, the light-emitting device O of Tandem EL design can emit light.

With reference to FIGS. 11 to 13, in some examples, by measuring a spectrum corresponding to an RGB image when a red light-emitting device (R) in the display substrate 100 emits light, a spectrum corresponding to an RGB image when a green light-emitting device (G) in the display substrate 100 emits light, and a spectrum corresponding to an RGB image when a blue light-emitting device (B) in the display substrate 100 emits light, it can be seen that the proportion of undesired peaks in the emission peak in the luminescence spectrum corresponding to light emitted by the light-emitting device O in at least part of sub-pixels P in the display substrate 100 is less than or equal to 5%. That is, in the case where no isolation column is added in the display substrate 100, the proportion of undesired peaks in the light emitted by the light-emitting device O may be reduced by adjusting various parameters of the charge generation stack layer 30, so that the proportion of undesired peaks in the emission peak in the luminescence spectrum corresponding to light emitted by the light-emitting device O in at least part of sub-pixels P in the display substrate 100 is less than or equal to 5%.

The measurement conditions for the red light-emitting device (R), the green light-emitting device (G) and the blue light-emitting device (B) in the display substrate 100 are consistent, and only the light-emitting device O to be measured is changed to facilitate observation of the undesired peaks of the light-emitting devices O emitting different light.

For example, the CS2000 equipment is used at room temperature to measure the spectrum corresponding to the RGB image when the red light-emitting device (R) in the display substrate 100 emits light, the spectrum corresponding to the RGB image when the green light-emitting device (G) in the display substrate 100 emits light, and the spectrum corresponding to the RGB image when the blue light-emitting device (B) in the display substrate 100 emits light. However, the embodiments of the present disclosure are not limited thereto.

It will be noted that in the spectrum of light emission of the red light-emitting device (R), the spectrum of light emission of the green light-emitting device (G), and the spectrum of light emission of the blue light-emitting device (B), only one dominant peak will appear if there is no crosstalk, and other undesired peaks will appear if there is crosstalk. That is, the "undesired peaks" are crosstalk peaks other than the dominant peak in the spectrum. The proportion of undesired peaks may be obtained by normalizing the intensity of the dominant peak. In addition, the "proportion of undesired peaks" mentioned below are also obtained in the above manner.

In the case where the proportion of undesired peaks of the light emitted by the light-emitting device O is equal to or close to 5%, the proportion of undesired peaks of the light emitted by the light-emitting device O is small. That is, the crosstalk problem of adjacent light-emitting devices O when a light-emitting device O of a single color emits light is mitigated, which may be conducive to ameliorating the color cast of the display substrate 100 and improving the display quality of the display substrate 100.

In the case where the proportion of undesired peaks of the light emitted by the light-emitting device O is equal to or close to 0%, the proportion of undesired peaks of the light emitted by the light-emitting device O may be negligible. That is, the crosstalk problem of adjacent light-emitting devices O when a light-emitting device O of a single color emits light may be effectively mitigated, which may prevent the color cast of the display substrate 100 and in turn improve the display quality of the display substrate 100.

In some examples, the proportion of undesired peaks in the emission peak in the luminescence spectrum corresponding to light emitted by the light-emitting device O in at least part of sub-pixels P in the display substrate 100 is less than or equal to 4%.

In the case where the proportion of undesired peaks of the light emitted by the light-emitting device O is equal to or close to 4%, the proportion of undesired peaks of the light emitted by the light-emitting device O may be smaller. That is, the crosstalk problem of adjacent light-emitting devices O when a light-emitting device O of a single color emits light may be mitigated well. Therefore, the color cast of the display substrate 100 may be reduced well, and the display quality of the display substrate 100 is improved.

For example, the proportion of undesired peaks in the emission peak in the luminescence spectrum corresponding to light emitted by the light-emitting device O in at least part of sub-pixels P is approximately any one of 0%, 0.5%, 1%, 1.5%, 2%, 2.5%, 3%, 3.5% or 4%.

It will be noted that "at least part of sub-pixels P" may include the following situations.

The first situation is that the proportion of undesired peaks in the emission peak in the luminescence spectrum corresponding to light emitted by part of sub-pixels P is less than or equal to 5%. Here, the "part of sub-pixels P" includes at least one of: a sub-pixel P with a light-emitting device that emits red light, a sub-pixel P with a light-emitting device that emits green light, or a sub-pixel P with a light-emitting device that emits blue light.

The second situation is that the proportion of undesired peaks in the emission peak in the luminescence spectrum corresponding to light emitted by all the sub-pixels P is less than or equal to 5%. That is, the proportion of undesired peaks in the emission peak in the luminescence spectrum corresponding to light emitted by the light-emitting device O in any one sub-pixel P in the display substrate 100 is less than or equal to 5%.

Based on this, the crosstalk problem of adjacent light-emitting devices O when a light-emitting device O of a single color emits light may be effectively mitigated, which may prevent the color cast of the display substrate 100 and in turn improve the display quality of the display substrate 100.

Specifically, with reference to FIGS. 8 and 11, or with reference to FIGS. 9 and 12, or with reference to FIGS. 10 and 13, in the display substrate 100 provided in the embodiments of the present disclosure, the proportion of undesired peaks of the light emitted by the light-emitting device O is less than or equal to 5%. That is, the technical effects similar to that of providing isolation column(s) may be achieved without additional isolation column(s). When a light-emitting device O of a certain color emits light, crosstalk to adjacent light-emitting devices O may be reduced. Therefore, the color cast of the display substrate 100 is ameliorated, which improves the display quality of the display substrate 100.

In summary, in the display substrate 100 provided in the embodiments of the present disclosure, the proportion of undesired peaks of the light emitted by the light-emitting device O is less than or equal to 5% without increasing the process and cost. Therefore, when a light-emitting device O of a certain color emits light, crosstalk to adjacent light-emitting devices O may be reduced. The color cast of the display substrate 100 is ameliorated, which improves the display quality of the display substrate 100.

In some embodiments, with continued reference to FIGS. 4 and 11 to 13, when the grayscale of the light-emitting device O in the sub-pixel P is higher than a threshold grayscale, the proportion of undesired peaks in the emission peak in the luminescence spectrum corresponding to light emitted by the light-emitting device O in at least part of sub-pixels P is approximately 0%.

In some examples, the threshold grayscale may be 128-grayscale. For example, 0-grayscale to 128-grayscale are low grayscales, and 129-grayscale to 255-grayscale are high grayscales. However, the embodiments of the present disclosure are not limited thereto. The following description is made by taking an example in which the threshold grayscale is 128-grayscale.

When the grayscale of the light-emitting device O in the sub-pixel P is higher than the threshold grayscale, the light-emitting device O in the sub-pixel P is in a high grayscale state.

Considering 255-grayscale as an example for introduction, the brightness of the first sub-pixel P1 (red) may be 300 Lum./nit, the brightness of the second sub-pixel P2 (green) may be 1000 Lum./nit, and the brightness of the third sub-pixel P3 (blue) may be 100 Lum./nit. Herein, 255-grayscale is introduced by taking the above brightness as an example.

Among the light-emitting device O in the first sub-pixel P1 (red), the light-emitting device O in the second sub-pixel P2 (green) and the light-emitting device O in the third sub-pixel P3 (blue), the proportion of undesired peaks generated by a light-emitting device O in one sub-pixel P due to the impact of light-emitting devices O in the other two sub-pixels P is approximately 0%.

Based on this, when the grayscale of the display substrate 100 is higher than the threshold grayscale, that is, the display substrate 100 is in a high grayscale state, the proportion of undesired peaks in the emission peak in the luminescence spectrum corresponding to light emitted by the light-emitting device O in at least part of sub-pixels P is approximately 0%, which is equivalent to removing undesired light of the light emitted by the light-emitting device O in at least part of sub-pixels P. Therefore, it may be possible to effectively ameliorate the color cast of the display substrate 100 and in turn improve the display quality of the display substrate 100.

It will be noted that due to certain uncontrollable errors (e.g., manufacturing process errors, equipment accuracy, measurement errors), in a case where the proportion of undesired peaks fluctuates within a range of ±0.5%, it may be considered that the proportion of undesired peaks satisfies the limiting condition of being equal to 0%. In addition, in some other examples, due to certain uncontrollable errors (e.g., manufacturing process errors, equipment accuracy, measurement errors), in a case where the proportion of undesired peaks fluctuates within a range of ±0.3%, it may also be considered that the proportion of undesired peaks satisfies the limiting condition of being equal to 0%.

In some embodiments, with continued reference to FIGS. 4 an 11 to 13, when the grayscale of the light-emitting device O in the sub-pixel P is lower than the threshold grayscale, the proportion of undesired peaks in the emission peak in the luminescence spectrum corresponding to light emitted by the light-emitting device O in at least part of sub-pixels P is less than or equal to 4%.

When the grayscale of the light-emitting device O in the sub-pixel P is lower than the threshold grayscale, the light-emitting device O in the sub-pixel P is in a low grayscale state.

Considering 8-grayscale as an example, the brightness of the first sub-pixel P1 (red) may be 0.1 Lum./nit, the brightness of the second sub-pixel P2 (green) may be 0.4 Lum./nit, and the brightness of the third sub-pixel P3 (blue) may be 0.06 Lum./nit. Herein, 8-grayscale is introduced by taking the above brightness as an example.

Among the light-emitting device O in the first sub-pixel P1 (red), the light-emitting device O in the second sub-pixel P2 (green) and the light-emitting device O in the third sub-pixel P3 (blue):

The proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%.

The proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%.

The proportion of undesired peaks generated by the light-emitting device O in the third sub-pixel P3 (blue) due to the impact of the light-emitting device O in the first sub-pixel P1 (red) is less than or equal to 4%. The proportion of undesired peaks generated by the light-emitting device O in the third sub-pixel P3 (blue) due to the impact of the light-emitting device O in the second sub-pixel P2 (green) is less than or equal to 3%.

Based on this, when the grayscale of the display substrate 100 is lower than the threshold grayscale, that is, when the display substrate 100 is in a low grayscale state, the proportion of undesired peaks in the emission peak in the luminescence spectrum corresponding to light emitted by the light-emitting device O in at least part of sub-pixels P is less than or equal to 4%, and the proportion of undesired peaks of the light emitted by the light-emitting device O is relatively small. The crosstalk problem of adjacent light-emitting devices O when a light-emitting device O of a single color emits light is mitigated, which may be conducive to ameliorating the color cast of the display substrate 100 and improving the display quality of the display substrate 100.

With reference to related drawings, the following description will introduce which parameters of the charge generation stack layer 30 are adjusted to reduce the proportion of undesired peaks of the light emitted by the light-emitting device O and ameliorate the color cast of the display substrate 100.

In some embodiments, as shown in FIGS. 4 and 11 to 13, the lateral resistance of the charge generation stack layer 30 is greater than or equal to 100 GΩ/µm². The holes and electrons in the charge generation stack layer 30 may be effectively suppressed from being laterally transported to adjacent light-emitting devices O, so that the proportion of undesired peaks in the emission peak in the luminescence spectrum corresponding to light emitted by the light-emitting device O is less than or equal to 5%, which is conducive to ameliorating the color cast of the display substrate 100 and improving the display quality of the display substrate 100.

When the lateral resistance of the charge generation stack layer 30 is equal to or close to 100 GΩ/µm², the lateral resistance of the charge generation stack layer 30 is relatively large, so that the holes and electrons in the charge generation stack layer 30 may be effectively suppressed from being laterally transported to adjacent light-emitting devices O. That is, it may be possible to avoid the color crosstalk between adjacent light-emitting devices O in the display substrate 100 and ameliorate the color cast of the display substrate 100.

In some examples, the lateral resistance of the charge generation stack layer 30 is greater than or equal to 120 GΩ/µm². When the lateral resistance of the charge generation stack layer 30 is equal to or close to 120 GΩ/µm², the lateral resistance of the charge generation stack layer 30 may be relatively large, so that the holes and electrons in the charge generation stack layer 30 may be effectively suppressed from being laterally transported to adjacent light-emitting devices O. Therefore, the color crosstalk between adjacent light-emitting devices O is ameliorated well, the color cast of the display substrate 100 is ameliorated, and the display quality of the display substrate 100 is improved.

It will be understood that in some other examples, the lateral resistance of the charge generation stack layer 30 is greater than or equal to 150 GΩ/µm². Alternatively, in yet some other embodiments, the lateral resistance of the charge generation stack layer 30 is greater than or equal to 200 GΩ/µm². However, the present disclosure is not limited thereto. The greater the lateral resistance of the charge generation stack layer 30, the better the suppression effect on the lateral transport of holes and electrons in the charge generation stack layer 30. Based on this, the greater the lateral resistance of the charge generation stack layer 30, the more obvious the effect of ameliorating the color cast of the display substrate 100.

For example, the above-mentioned "lateral resistance of the charge generation stack layer 30" may be obtained in the following manner: determining an IV curve of a structure between two electrodes (the first electrode 10 and the second electrode 50) at a distance of 10 µm to 100 µm using IVL equipment, and then calculating the lateral resistance (by dividing voltage by current). In addition, the "lateral resistance" hereinafter is obtained in the manner described above. However, the manner for measuring the lateral resistance of the charge generation stack layer 30 in the embodiments of the present disclosure is not limited thereto.

In some embodiments, as shown in FIGS. 4 and 11 to 13, the lateral resistance of the charge generation stack layer 30 is less than or equal to 260 GΩ/µm².

The material, doping and other conditions of the charge generation stack layer 30 need to be adjusted such that the lateral resistance of the charge generation stack layer 30 is relatively large, but other characteristics of the charge generation stack layer 30 will also be affected and even the life of the formed light-emitting device O will be affected. In view of this, the lateral resistance of the charge generation stack layer 30 needs to be limited to be less than or equal to 260 GΩ/µm², so as to prevent the charge generation stack layer 30 from affecting the life of the light-emitting device O and affecting the quality of the display substrate 100.

When the lateral resistance of the charge generation stack layer 30 is equal to or close to 260 GΩ/µm², the lateral resistance of the charge generation stack layer 30 may be larger without affecting the life and performance of the finally formed light-emitting device O. The lateral resistance of the charge generation stack layer 30 may be used to suppress the lateral transport of the holes and electrons in the charge generation stack layer 30 to adjacent light-emitting devices O. Therefore, the color crosstalk between adjacent light-emitting devices O is ameliorated, the color cast of the display substrate 100 is ameliorated, and the display quality of the display substrate 100 is improved.

In some examples, the lateral resistance of the charge generation stack layer 30 is less than or equal to 230 GΩ/µm². When the lateral resistance of the charge generation stack layer 30 is equal to or close to 230 GΩ/µm², the lateral resistance of the charge generation stack layer 30 may be relatively small, thereby further preventing the problem of affecting the life of the formed light-emitting device O.

It will be understood that in some other examples, the lateral resistance of the charge generation stack layer 30 is less than or equal to 210 GΩ/µm². However, the embodiments of the present disclosure are not limited thereto.

In some embodiments, as shown in FIGS. 4 and 11 to 13, the lateral resistance of the charge generation stack layer 30 is in a range of 100 GΩ/µm² to 260 GΩ/µm². The lateral resistance of the charge generation stack layer 30 may effectively suppress the lateral transport of the holes and electrons in the charge generation stack layer 30 to adjacent light-emitting devices O, so as to ameliorating the color cast of the display substrate 100 to a great extent; in addition, it may also avoid that the required lateral resistance of the charge generation stack layer 30 is too large, which affects the life of the formed light-emitting device O.

In some other examples, the lateral resistance of the charge generation stack layer 30 is in a range of 124 GΩ/µm² to 254 GΩ/µm². In yet some other examples, the lateral resistance of the charge generation stack layer 30 is in a range of 113 GΩ/µm² to 231 GΩ/µm². However, the embodiments of the present disclosure are not limited thereto.

For example, the lateral resistance of the charge generation stack layer 30 is approximately any one of 100 GΩ/µm², 150 GΩ/µm², 200 GΩ/µm², 250 GΩ/µm² or 260 GΩ/µm². However, the embodiments of the present disclosure are not limited thereto.

It will be noted that, considering an example in which the lateral resistance value of the charge generation stack layer 30 is approximately 260 GΩ/µm² for introduction, due to certain uncontrollable errors (e.g., manufacturing process errors, equipment accuracy, measurement errors), in a case where the lateral resistance of the charge generation stack layer 30 fluctuates within a range of 10% × 260 GΩ/µm², it may also be considered that the lateral resistance of the charge generation stack layer 30 satisfies the condition of being equal to 260 GΩ/µm².

In addition, in some other examples, due to certain uncontrollable errors (e.g., manufacturing process errors, equipment accuracy, measurement errors), in a case where the lateral resistance of the charge generation stack layer 30 fluctuates within a range of 5% × 260 GΩ/µm², it may also be considered that the lateral resistance of the charge generation stack layer 30 satisfies the condition of being equal to 260 GΩ/µm².

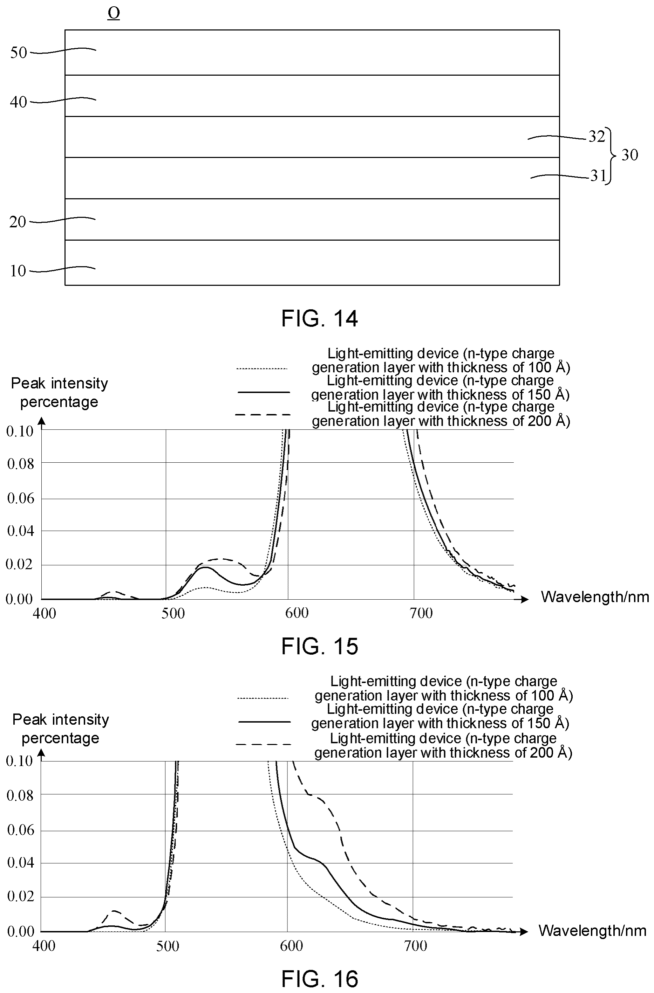

FIG. 14 is a structural diagram of a light-emitting device, in accordance with some other embodiments.

In some embodiments, referring to FIG. 14, the charge generation stack layer 30 includes an n-type charge generation layer 31 and a p-type charge generation layer 32, and the p-type charge generation layer 32 is located on a side of the n-type charge generation layer 31 away from the first electrode 10. The charge generation stack layer 30 is configured such that the n-type charge generation layer 31 transports electrons to the first light-emitting unit 20 and the p-type charge generation layer 32 transports holes to the second light-emitting unit 40.

The n-type charge generation layer 31 and the p-type charge generation layer 32 may constitute a PN junction, and a space charge region is created at an interface between the n-type charge generation layer 31 and the p-type charge generation layer 32 to generate holes and electrons. Thereby, the first electrode 10 and the second electrode 50 cooperate to make the light-emitting device O emit light.

In some examples, the n-type charge generation layer 31 includes a first-kind n-type charge generation layer and a second-kind n-type charge generation layer. A lateral resistance of the first-kind n-type charge generation layer is greater than a lateral resistance of the second-kind n-type charge generation layer.

In the case where the n-type charge generation layer 31 is the first-kind n-type charge generation layer, the first-kind n-type charge generation layer and the p-type charge generation layer constitute the charge generation layer 31, so that the lateral resistance of the charge generation stack layer 30 is in a range of 100 GΩ/µm² to 260 GΩ/µm². Therefore, the charge generation stack layer 30 may effectively suppress the lateral transport of the holes and electrons in the charge generation stack layer 30 to adjacent light-emitting devices O and ameliorate the color cast of the display substrate 100; in addition, it may also prevent the life of the formed light-emitting device O from being affected.

In some examples, the n-type charge generation layer 31 includes a first-kind n-type charge generation layer and a second-kind n-type charge generation layer. A lateral resistance of the first-kind n-type charge generation layer is greater than a lateral resistance of the second-kind n-type charge generation layer. The p-type charge generation layer 32 includes a first-kind p-type charge generation layer and a second-kind p-type charge generation layer. A lateral resistance of the first-kind p-type charge generation layer is greater than a lateral resistance of the second-kind p-type charge generation layer.

For example, in the case where the n-type charge generation layer 31 is the first-kind n-type charge generation layer and the p-type charge generation layer 32 is the first-kind p-type charge generation layer, the lateral resistance of the charge generation stack layer 30 may be in a range of 124 GΩ/µm² to 254 GΩ/µm².

For example, in the case where the n-type charge generation layer 31 is the first-kind n-type charge generation layer and the p-type charge generation layer 32 is the second-kind p-type charge generation layer, the lateral resistance of the charge generation stack layer 30 may be in a range of 113 GΩ/µm² to 231 GΩ/µm².

For example, in the case where the n-type charge generation layer 31 is the second-kind n-type charge generation layer, regardless of whether the p-type charge generation layer 32 is the first-kind p-type charge generation layer or the second-kind p-type charge generation layer, the lateral resistance of the charge generation stack layer 30 composed of the n-type charge generation layer 31 and the p-type charge generation layer 32 is in a range of 50 GΩ/µm² to 130 GΩ/µm².

For example, in the case where the n-type charge generation layer 31 is the second-kind n-type charge generation layer and the p-type charge generation layer 32 is the first-kind p-type charge generation layer, the lateral resistance of the charge generation stack layer 30 may be in a range of 60 GΩ/µm² to 127 GΩ/µm².

For example, in the case where the n-type charge generation layer 31 is the second-kind n-type charge generation layer and the p-type charge generation layer 32 is the second-kind p-type charge generation layer, the lateral resistance of the charge generation stack layer 30 may be in a range of 56 GΩ/µm² to 116 GΩ/µm².

It will be noted that the material of the n-type charge generation layer 31 and the material of the p-type charge generation layer 32 are not limited in the embodiments of the present disclosure, which may be modified and adjusted based on the lateral resistance of the formed charge generation stack layer 30 according to actual needs, so as to satisfy the limitation on the lateral resistance of the charge generation stack layer 30 in any of the above embodiments.

Based on the above description, it will be known that, as shown in FIGS. 11 to 14, in a case where a material with a large lateral resistance is selected for the n-type charge generation layer 31, no matter a material with a larger lateral resistance or a smaller lateral resistance is selected for the p-type charge generation layer 32, the lateral resistance of the charge generation layer composed of the n-type charge generation layer 31 and the p-type charge generation layer 32 may be in a range of 100 GΩ/µm² to 260 GΩ/µm². The charge generation stack layer 30 may effectively suppress the lateral transport of the holes and electrons in the charge generation stack layer 30 to adjacent light-emitting devices O, so that the proportion of undesired peaks of the light emitted by the light-emitting device O is less than or equal to 4%. The color cast of the display substrate 100 is ameliorated. In addition, it may also prevent the life of the formed light-emitting device O from being affected.

In the case where a material with a small lateral resistance is selected for the n-type charge generation layer 31, no matter a material with a larger lateral resistance or a smaller lateral resistance is selected for the p-type charge generation layer 32, the lateral resistance of the charge generation stack layer 30 composed of the n-type charge generation layer 31 and the p-type charge generation layer 32 may be in a range of 50 GΩ/µm² to 130 GΩ/µm². As a result, the lateral resistance of the formed charge generation stack layer 30 is not completely within a good range (100 GΩ/µm² to 260 GΩ/µm²), which may suppress the lateral transport of holes and electrons in the charge generation stack layer 30 to a certain extent, but the color cast of the display substrate 100 may not be completely ameliorated.

In order to further ameliorate the color cast of the display substrate 100, in the following description, some other parameters of the charge generation stack layer 30 may be adjusted to ameliorate the color cast of the display substrate 100 to a great extent. The improvement of the thickness of the charge generation layer may be firstly described.

The n-type charge generation layer 31 is close to a side of the p-type charge generation layer 32. The first electrode 10, the first light-emitting unit 20, and the n-type charge generation layer 31 in the charge generation stack layer 30 may constitute an independent light-emitting element. The n-type charge generation layer 31 is used to generate electrons moving toward the first light-emitting unit 20, and the first electrode is used to generate holes moving toward the first light-emitting unit 20.

It has been found through research that a rate at which holes move is higher than a rate at which electrons move. Based on this, holes with the higher moving rate may accumulate, resulting in the lateral movement.

In view of the above problem, in some embodiments, referring to FIG. 14, a minimum distance between a surface of the n-type charge generation layer 31 close to the p-type charge generation layer 32 and the first light-emitting unit 20 may be set to be smaller than a minimum distance between a surface of the first electrode 10 away from the first light-emitting unit 20 and the first light-emitting unit 20.

That is, a transport path of electrons generated in the n-type charge generation layer 31 is set to be smaller than a transport path of electrons generated in the first electrode 10. The transport path of electrons may be shortened to compensate for the fact that the rate at which electrons move is lower than the rate at which holes move.

Based on this, the electrons generated by the n-type charge generation layer 31 and the holes generated by the first electrode 10 will be timely recombined in the first light-emitting unit 20 to form excitons, so as to prevent the lateral crosstalk caused by the accumulation of holes, which is conducive to improving the display quality of the display substrate 100.

In some embodiments, referring to FIG. 14, a thickness of the n-type charge generation layer 31 in the charge generation stack layer 30 is in a range of 50 Å to 250 Å.

In the case where the thickness of the n-type charge generation layer 31 is equal to 50 Å, the transport path of the electrons generated in the n-type charge generation layer 31 may be relatively short, thereby reducing the time required for transporting the electrons generated in the n-type charge generation layer 31 to the first light-emitting unit 20 to compensate for the fact that the rate at which electrons move is lower than the rate at which holes move. The electrons generated by the n-type charge generation layer 31 and the holes generated by the first electrode 10 will be timely recombined in the first light-emitting unit 20 to form excitons, so as to prevent the lateral crosstalk caused by the accumulation of holes, which is conducive to improving the display quality of the display substrate 100. Moreover, in the case where the thickness of the n-type charge generation layer 31 is equal to 50 Å, it may also avoid that the thickness of the n-type charge generation layer 31 is too small, which affects the cavity effect of the light-emitting device O.

In the case where the thickness of the n-type charge generation layer 31 is equal to 250 Å, it may avoid that the thickness of the n-type charge generation layer 31 is too small, which affects the cavity effect of the light-emitting device O; in addition, the transport path of the electrons generated in the n-type charge generation layer 31 may be shortened, thereby preventing the lateral crosstalk caused by the accumulation of holes.

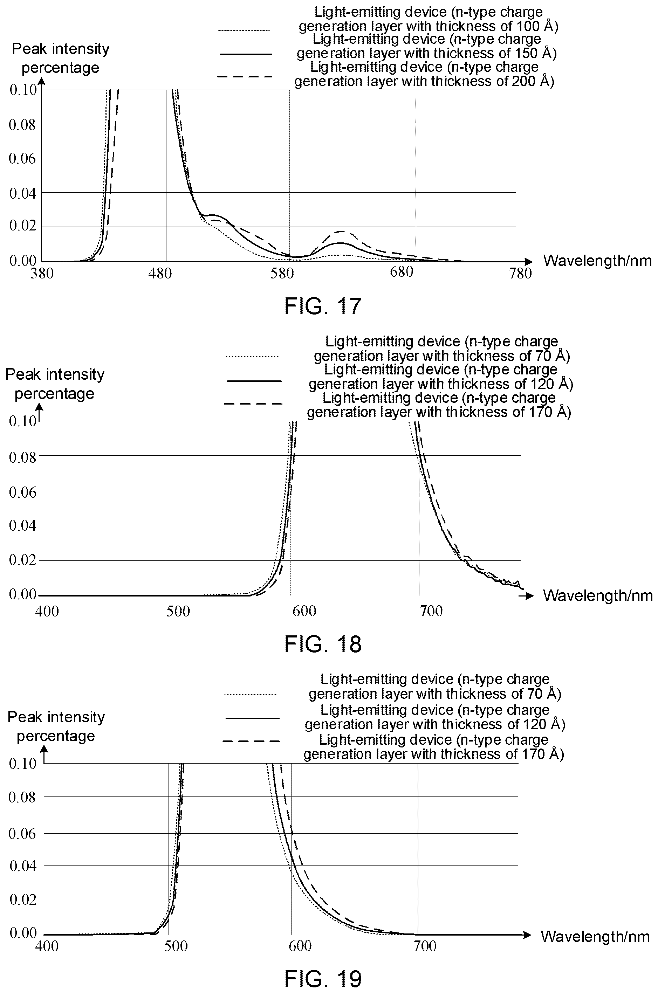

FIG. 15 is a spectrum diagram of a light-emitting device for emitting red light, in accordance with some other embodiments. FIG. 16 is a spectrum diagram of a light-emitting device for emitting green light, in accordance with some other embodiments. FIG. 17 is a spectrum diagram of a light-emitting device for emitting blue light, in accordance with some other embodiments. FIGS. 15 to 17 each illustrate an example in which the grayscale of the light-emitting device O in the display substrate 100 is a high grayscale (e.g., 255-grayscale) and the n-type charge generation layer 31 is the second-kind n-type charge generation layer.

In some examples, as shown in FIGS. 4 and 15 to 17, the improvement effect on the color cast of the display substrate 100 when the n-type charge generation layer 31 is the second-kind n-type charge generation layer is not as good as the improvement effect on the color cast of the display substrate 100 when the n-type charge generation layer 31 is the first-kind n-type charge generation layer. Based on this, the n-type charge generation layer 31 as the second-kind n-type charge generation layer will be firstly introduced as an example. The thickness of the second-kind n-type charge generation layer was adjusted for experiments. Specifically, a spectrum when the thickness of the second-kind n-type charge generation layer is 100 Å, a spectrum when the thickness of the second-kind n-type charge generation layer is 150 Å, and a spectrum when the thickness of the second-kind n-type charge generation layer is 200 Å are illustrated.

Referring to FIGS. 15 to 17, it can be seen that when the thickness of the second-kind n-type charge generation layer is in a range of 50 Å to 250 Å, the proportion of undesired peaks of the light emitted by the light-emitting device O may be reduced, thereby ameliorating the color cast of the display substrate 100. Referring to FIGS. 15 to 17, regardless of the color of light emitted by the light-emitting device O, the smaller the thickness of the second-kind n-type charge generation layer in the light-emitting device O is, the smaller the proportion of undesired peaks of the light emitted by the light-emitting device O is, and the better the effect of ameliorating the color cast of the display substrate 100 is.

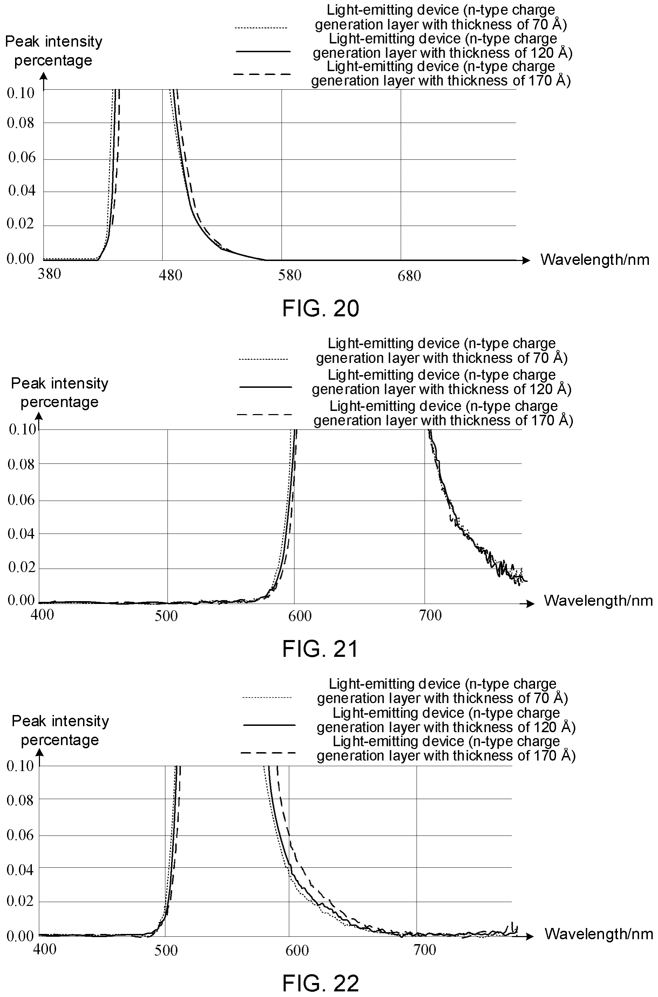

FIG. 18 is a spectrum diagram of a light-emitting device for emitting red light, in accordance with yet some other embodiments. FIG. 19 is a spectrum diagram of a light-emitting device for emitting green light, in accordance with yet some other embodiments. FIG. 20 is a spectrum diagram of a light-emitting device for emitting blue light, in accordance with yet some other embodiments. FIGS. 15 to 17 each illustrate an example in which the grayscale of the light-emitting device O in the display substrate 100 is a high grayscale (e.g., 255-grayscale) and the n-type charge generation layer 31 is the first-kind n-type charge generation layer.

In some other examples, referring to FIG. 4, the difference between the spectra shown in FIGS. 18 to 20 and the spectra shown in FIGS. 15 to 17 is that: the n-type charge generation layer 31 in the light-emitting device O is the first-kind n-type charge generation layer.

Referring to the spectra shown in FIGS. 18 to 20 and the spectra shown in FIGS. 15 to 17, firstly, it can be obviously seen that the proportion of undesired peaks of the light emitted by the light-emitting device O when the n-type charge generation layer 31 in the light-emitting device O is the first-kind n-type charge generation layer is smaller than the proportion of undesired peaks of the light emitted by the light-emitting device O when the n-type charge generation layer 31 in the light-emitting device O is the second-kind n-type charge generation layer, resulting in good effect of ameliorating the color cast of the display substrate 100.

Then, referring to the spectra shown in FIGS. 18 to 20, on the basis that the n-type charge generation layer 31 in the light-emitting device O is the first-kind n-type charge generation layer, the thickness of the first-kind n-type charge generation layer is adjusted to test the impact of the first-kind n-type charge generation layer with different thicknesses on undesired peaks of the light emitted by the light-emitting device O. Specifically, the thicknesses of the n-type charge generation layer are 70 Å, 120 Å, and 170 Å.

As shown in FIGS. 18 to 20, it can be seen that when the thickness of the first-kind n-type charge generation layer is in a range of 50 Å to 250 Å, the proportion of undesired peaks of the light emitted by the light-emitting device O is relatively small, thereby ameliorating the color cast of the display substrate 100.

Specifically, as shown in FIG. 18, the proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%.

As shown in FIG. 19, the proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%.

As shown in FIG. 20, the proportion of undesired peaks generated by the light-emitting device O in the third sub-pixel P3 (blue) due to the impact of the light-emitting device O in the first sub-pixel P1 (red) and the light-emitting device O in the second sub-pixel P2 (green) is approximately 0%.

In summary, among the light-emitting device O in the first sub-pixel P1 (red), the light-emitting device O in the second sub-pixel P2 (green) and the light-emitting device O in the third sub-pixel P3 (blue), the proportion of undesired peaks generated by a light-emitting device O in one sub-pixel P due to the impact of light-emitting devices O in the other two sub-pixels P is approximately 0%. That is, regardless of the color of light emitted by the light-emitting device O, the smaller the thickness of the first-kind n-type charge generation layer in the light-emitting device O is, the smaller the proportion of undesired peaks of the light emitted by the light-emitting device O is, and the better the effect of ameliorating the color cast of the display substrate 100 is.

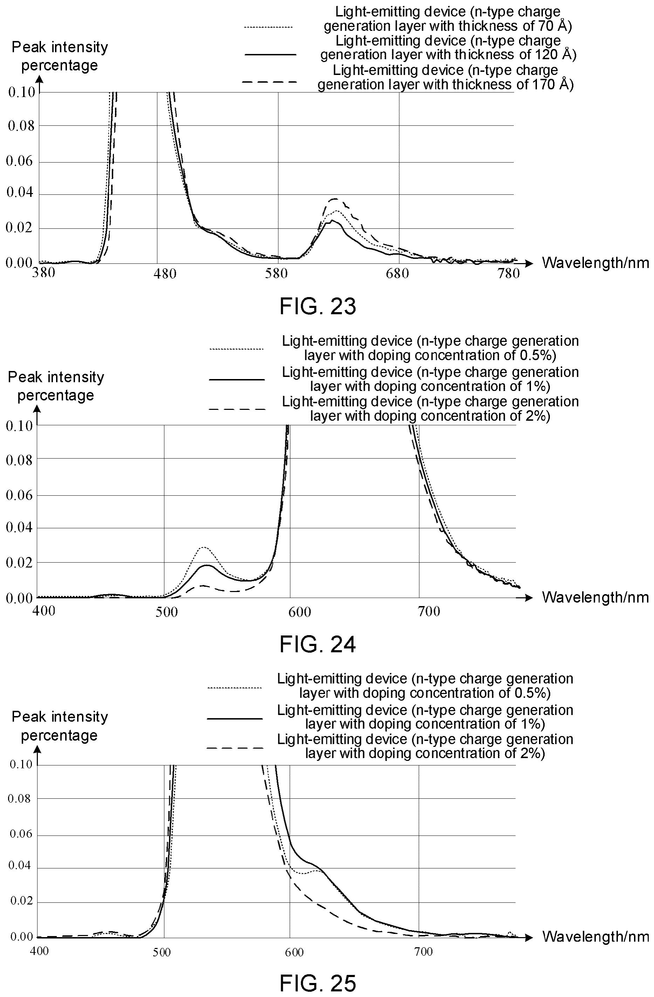

FIG. 21 is a spectrum diagram of a light-emitting device for emitting red light, in accordance with yet some other embodiments. FIG. 22 is a spectrum diagram of a light-emitting device for emitting green light, in accordance with yet some other embodiments. FIG. 23 is a spectrum diagram of a light-emitting device for emitting blue light, in accordance with yet some other embodiments. The difference between the spectra shown in FIGS. 21 to 23 and the spectra shown in FIGS. 18 to 20 is as follows.

The color cast of the display substrate 100 in a low grayscale state is more obvious than the color cast of the display substrate 100 in a high grayscale state. Then, based on FIGS. 18 to 20, only the grayscale of the light-emitting device O was changed for experiments. Specifically, the grayscale of the light-emitting device O in the display substrate 100 as a low grayscale (e.g., 8-grayscale) is taken as an example for description.

As shown in FIGS. 21 to 23, it can be seen that in the low grayscale state, the proportion of undesired peaks of the light emitted by the light-emitting device O may also be small when the thickness of the first-kind n-type charge generation layer is in a range of 50 Å to 250 Å, so that the color cast of the display substrate 100 may be ameliorated.

Specifically, as shown in FIG. 21, the proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%.

As shown in FIG. 22, the proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%.

As shown in FIG. 23, the proportion of undesired peaks generated by the light-emitting device O in the third sub-pixel P3 (blue) due to the impact of the light-emitting device O in the first sub-pixel P1 (red) is less than or equal to 3%; and the proportion of undesired peaks generated by the light-emitting device O in the third sub-pixel P3 (blue) due to the impact of the light-emitting device O in the second sub-pixel P2 (green) is less than or equal to 2.5%.

In summary, in the low grayscale state, the undesired peaks of the light-emitting device O emitting red light and the light-emitting device O emitting green light are basically removed, and the light-emitting device O emitting blue light still has undesired peaks to a certain extent. However, the proportion of undesired peaks of the light emitted by the light-emitting device O emitting blue light may be made less than 4%, and the color cast of the display substrate 100 may be ameliorated.

Moreover, when the thickness of the first-kind n-type charge generation layer is in a range of 50 Å to 250 Å, regardless of the color of light emitted by the light-emitting device O, the smaller the thickness of the first-kind n-type charge generation layer in the light-emitting device O is, the smaller the proportion of undesired peaks of the light emitted by the light-emitting device O is, and the better the effect of ameliorating the color cast of the display substrate 100 is.

The light-emitting device O emitting blue light shown in FIG. 23 is particularly clear. The thickness of the first-kind n-type charge generation layer may be further adjusted to further improve the effect of ameliorating the color cast of the display substrate 100.

Referring to Table 1 and FIGS. 18 to 23, it can be seen that when the thickness of the n-type charge generation layer varies, color coordinates at 255-grayscale and 8-grayscale have small difference, which may be conducive to improving the effect of ameliorating the color cast of the display substrate 100.

**Table 1 shows difference between color coordinates at 255-grayscale and 8-grayscale at different thicknesses of n-type charge generation layer**

| | Difference | | |
|---|---|---|---|
| | The thickness of the n-type charge generation layer 31 is 70 Å | The thickness of the n-type charge generation layer 31 is 120 Å | The thickness of the n-type charge generation layer 31 is 170 Å |
| Light-emitting device O emitting red light | 0.000 | 0.001 | 0.002 |
| Light-emitting device O emitting green light | 0.003 | 0.003 | 0.003 |
| Light-emitting device O emitting blue light | 0.012 | 0.016 | 0.020 |

For the light-emitting device O emitting red light and the light-emitting device O emitting green light, difference on the X-axis (X-coordinate in color coordinates) is determined. For the light-emitting device O emitting blue light, difference on the Y-axis (Y-coordinate in color coordinates) is determined.

In some embodiments, as shown in FIGS. 14 to 23, the thickness of the n-type charge generation layer 31 in the charge generation stack layer 30 is in a range of 50 Å to 70 Å.

In the case where the thickness of the n-type charge generation layer 31 is equal to 50 Å, the transport path of the electrons generated in the n-type charge generation layer 31 may be relatively short, thereby reducing the time required for transporting the electrons generated in the n-type charge generation layer 31 to the first light-emitting unit 20 to compensate for the fact that the rate at which electrons move is lower than the rate at which holes move. The electrons generated by the n-type charge generation layer 31 and the holes generated by the first electrode 10 will be timely recombined in the first light-emitting unit 20 to form excitons, so as to prevent the lateral crosstalk caused by the accumulation of holes, which is conducive to improving the display quality of the display substrate 100. Moreover, in the case where the thickness of the n-type charge generation layer 31 is equal to 50 Å, it may also avoid that the thickness of the n-type charge generation layer 31 is too small, which affects the cavity effect of the light-emitting device O.

In the case where the thickness of the n-type charge generation layer 31 is equal to 70 Å, the thickness of the n-type charge generation layer 31 may be small, and it may effectively avoid that the thickness of the n-type charge generation layer 31 is too small, which affects the cavity effect of the light-emitting device O; in addition, it may also shorten the transport path of the electrons generated in the n-type charge generation layer 31 to a great extent, and in turn prevent the lateral crosstalk caused by the accumulation of holes.

In some embodiments, as shown in FIGS. 14 to 23, the thickness of the n-type charge generation layer 31 is approximately 60 Å. Therefore, the thickness of the n-type charge generation layer 31 may be small, the transport path of the electrons generated in the n-type charge generation layer 31 is shortened, which prevents the lateral crosstalk caused by the accumulation of holes; in addition, it may also avoid that the thickness of the n-type charge generation layer 31 is too small, which affects the cavity effect of the light-emitting device O.

It will be understood that in some other embodiments, the thickness of the n-type charge generation layer 31 is approximately any one of 50 Å, 55 Å, 65 Å or 70 Å, which will not be limited in the embodiments of the present disclosure.

It will be noted that, considering an example in which the thickness of the n-type charge generation layer 31 is approximately 50 Å for introduction, due to certain uncontrollable errors (e.g., manufacturing process errors, equipment accuracy, measurement errors), in a case where the thickness of the n-type charge generation layer 31 fluctuates within a range of 10% × 50 Å, it may also be considered that the thickness of the n-type charge generation layer 31 satisfies the condition of being equal to 50 Å.

In addition, in some other examples, due to certain uncontrollable errors (e.g., manufacturing process errors, equipment accuracy, measurement errors), in a case where the thickness of the n-type charge generation layer 31 fluctuates within a range of 5% × 50 Å, it may also be considered that the thickness of the n-type charge generation layer 31 satisfies the condition of being equal to 50 Å.

With reference to relevant accompanying drawings, the above description introduces that "some other parameters" may include the thickness of the n-type charge generation layer in the charge generation stack layer 30, and the thickness of the n-type charge generation layer is adjusted to improve the effect of ameliorating the color cast of the display substrate 100. Then, the following description mainly introduces that "some other parameters" may further include the doping concentration of the charge generation layer, and specifically introduces how to adjust the doping concentration of the charge generation layer to improve the effect of ameliorating the color cast of the display substrate 100.

In some embodiments, as shown in FIG. 14, the n-type charge generation layer 31 in the charge generation stack layer 30 in the light-emitting device O is doped with a first foreign substance. The n-type charge generation layer 31 is doped with the first foreign substance, which may be conducive to improving electron mobility of the n-type charge generation layer 31 so that the n-type charge generation layer 31 and the p-type charge generation layer 32 constitute a PN junction (charge generation stack layer 30). Thus, the formed charge generation stack layer 30 may effectively generate electrons moving toward the first light-emitting unit 20 and holes moving toward the second light-emitting unit 40.

In some examples, the first foreign substance may be ytterbium (Yb). However, the embodiments of the present disclosure are not limited thereto.

In some examples, a doping concentration of the first foreign substance in the n-type charge generation layer 31 is in a range of 0.5% to 2%.

In the case where the doping concentration of the first foreign substance in the n-type charge generation layer 31 is equal to or close to 0.5%, the doping concentration of the p-type charge generation layer 32 is adjusted to make the n-type charge generation layer 31 and the p-type charge generation layer 32 have a good concentration difference, so that the electrons and holes in the n-type charge generation layer 31 and the p-type charge generation layer 32 will move. In addition, the electrons generated in the n-type charge generation layer 31 may move toward the first light-emitting unit 20, and the electrons generated in the p-type charge generation layer 32 may move toward the second light-emitting unit 40, so as to prevent the lateral transport caused by the accumulation of holes and electrons in the charge generation stack layer 30 composed of the n-type charge generation layer 31 and the p-type charge generation layer 32, and to prevent the color crosstalk between adjacent light-emitting devices O. Therefore, the color cast of the display substrate 100 is ameliorated, and the display quality of the display substrate 100 is improved.

In the case where the doping concentration of the first foreign substance in the n-type charge generation layer 31 is equal to or close to 2%, the doping concentration of the p-type charge generation layer 32 is adjusted to make the n-type charge generation layer 31 and the p-type charge generation layer 32 have a good concentration difference, so that the electrons and holes in the n-type charge generation layer 31 and the p-type charge generation layer 32 will move. In addition, the electrons generated in the n-type charge generation layer 31 may move toward the first light-emitting unit 20, and the electrons generated in the p-type charge generation layer 32 may move toward the second light-emitting unit 40, so as to prevent the lateral transport caused by the accumulation of holes and electrons in the charge generation stack layer 30 composed of the n-type charge generation layer 31 and the p-type charge generation layer 32, and to prevent the color crosstalk between adjacent light-emitting devices O. Therefore, the color cast of the display substrate 100 is ameliorated, and the display quality of the display substrate 100 is improved.

It will be noted that how to adjust the doping concentration of the p-type charge generation layer 32 will be described below with reference to accompanying drawings.

In some embodiments, as shown in FIG. 14, the p-type charge generation layer 32 in the charge generation stack layer 30 in the light-emitting device O is doped with a second foreign substance. The p-type charge generation layer 32 is doped with the second foreign substance, which may be conducive to improving hole mobility in the p-type charge generation layer 32 so that the p-type charge generation layer 32 and the n-type charge generation layer 31 constitute a PN junction (charge generation stack layer 30). Thus, the formed charge generation stack layer 30 may effectively generate electrons moving toward the first light-emitting unit 20 and holes moving toward the second light-emitting unit 40.

In some examples, the second foreign substance may be an organic substance. However, the embodiments of the present disclosure are not limited thereto. Any organic substance capable of improving the hole mobility of the p-type charge generation layer 32 may be used as the second foreign substance.

In some examples, a doping concentration of the second foreign substance in the p-type charge generation layer 32 is in a range of 5% to 15%.

In the case where the doping concentration of the second foreign substance in the p-type charge generation layer 32 is equal to or close to 5%, the doping concentration of the n-type charge generation layer 31 is adjusted to make the p-type charge generation layer 32 and the n-type charge generation layer 31 have a good concentration difference, so that the electrons and holes in the p-type charge generation layer 32 and the n-type charge generation layer 31 will move. In addition, the electrons generated in the p-type charge generation layer 32 may move toward the second light-emitting unit 40, and the electrons generated in the n-type charge generation layer 31 may move toward the first light-emitting unit 20, so as to prevent the lateral transport caused by the accumulation of holes and electrons in the charge generation stack layer 30 composed of the n-type charge generation layer 31 and the p-type charge generation layer 32, and to prevent the color crosstalk between adjacent light-emitting devices O. Therefore, the color cast of the display substrate 100 is ameliorated, and the display quality of the display substrate 100 is improved.

In the case where the doping concentration of the second foreign substance in the p-type charge generation layer 32 is equal to or close to 15%, the doping concentration of the n-type charge generation layer 31 is adjusted to make the p-type charge generation layer 32 and the n-type charge generation layer 31 have a good concentration difference, so that the electrons and holes in the p-type charge generation layer 32 and the n-type charge generation layer 31 will move. In addition, the electrons generated in the p-type charge generation layer 32 may move toward the second light-emitting unit 40, and the electrons generated in the n-type charge generation layer 31 may move toward the first light-emitting unit 20, so as to prevent the lateral transport caused by the accumulation of holes and electrons in the charge generation stack layer 30 composed of the n-type charge generation layer 31 and the p-type charge generation layer 32, and to prevent the color crosstalk between adjacent light-emitting devices O. Therefore, the color cast of the display substrate 100 is ameliorated, and the display quality of the display substrate 100 is improved.

It will be noted that how to adjust the doping concentration of the n-type charge generation layer 31 will be described below with reference to accompanying drawings.

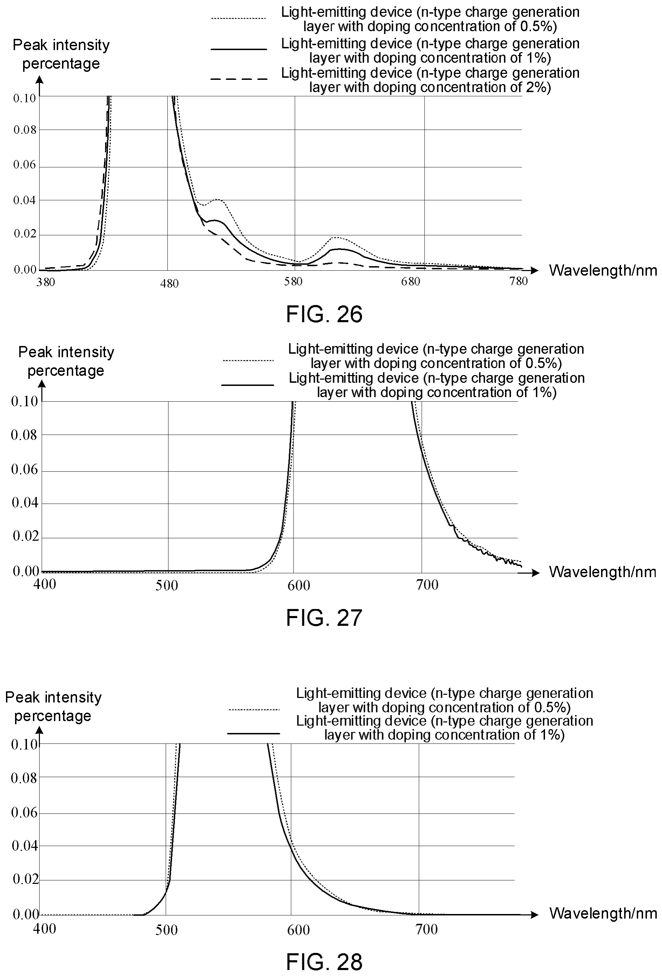

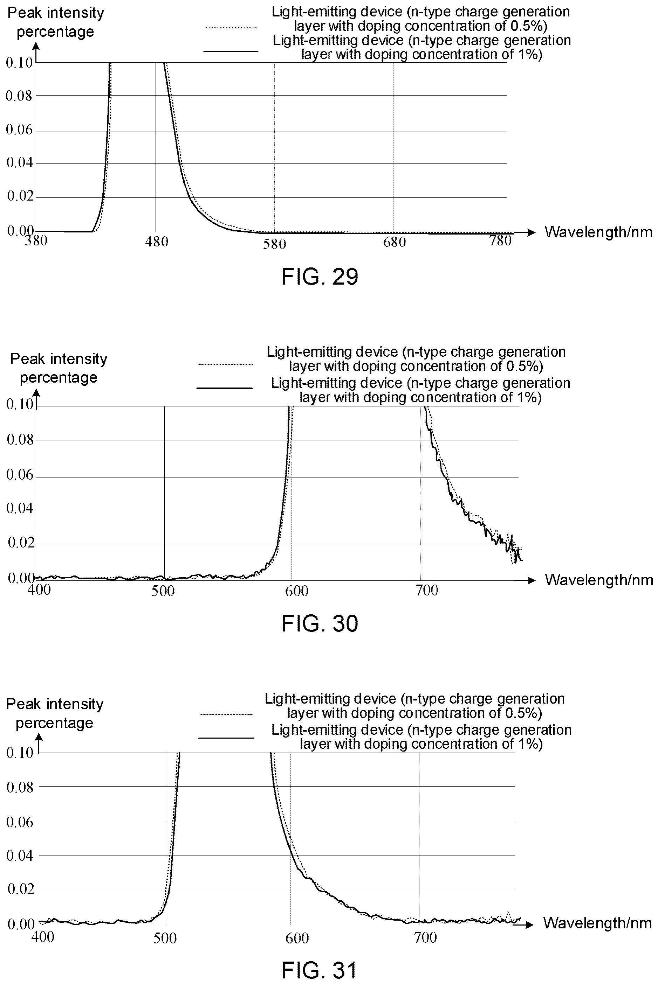

FIG. 24 is a spectrum diagram of a light-emitting device for emitting red light, in accordance with yet some other embodiments. FIG. 25 is a spectrum diagram of a light-emitting device for emitting green light, in accordance with yet some other embodiments. FIG. 26 is a spectrum diagram of a light-emitting device for emitting blue light, in accordance with yet some other embodiments. FIGS. 24 to 26 each illustrate an example in which the grayscale of the light-emitting device O in the display substrate 100 is a high grayscale (e.g., 255-grayscale) and the n-type charge generation layer 31 is the second-kind n-type charge generation layer. FIG. 27 is a spectrum diagram of a light-emitting device for emitting red light, in accordance with yet some other embodiments. FIG. 28 is a spectrum diagram of a light-emitting device for emitting green light, in accordance with yet some other embodiments. FIG. 29 is a spectrum diagram of a light-emitting device for emitting blue light, in accordance with yet some other embodiments. FIGS. 27 to 29 each illustrate an example in which the grayscale of the light-emitting device O in the display substrate 100 is a high grayscale (e.g., 255-grayscale) and the n-type charge generation layer 31 is the first-kind n-type charge generation layer.

The difference between the spectra shown in FIGS. 27 to 29 and the spectra shown in FIGS. 24 to 26 is that: the doping concentration of the second foreign substance in the p-type charge generation layer 32 of the light-emitting device O corresponding to the spectra shown in FIGS. 27 to 29 is 10%, and the doping concentration of the second foreign substance in the p-type charge generation layer 32 of the light-emitting device O corresponding to the spectra shown in FIGS. 24 to 26 is 5%.

In some embodiments, as shown in FIGS. 14 and 24 to 29, the doping concentration of the first foreign substance in the n-type charge generation layer 31 is negatively correlated with the doping concentration of the second foreign substance in the p-type charge generation layer 32.

The description "the doping concentration of the first foreign substance in the n-type charge generation layer 31 is negatively correlated with the doping concentration of the second foreign substance in the p-type charge generation layer 32" may be understood as, when the doping concentration of the second foreign substance in the p-type charge generation layer 32 is greater than or equal to a threshold doping concentration, the lower the doping concentration of the first foreign substance in the n-type charge generation layer 31 is, the better the formed charge generation stack layer 30 will ameliorate the color cast of the display substrate 100. When the doping concentration of the second foreign substance in the p-type charge generation layer 32 is less than the threshold doping concentration, the higher the doping concentration of the first foreign substance in the n-type charge generation layer 31 is, the better the formed charge generation stack layer 30 will ameliorate the color cast of the display substrate 100.

In some examples, the threshold doping concentration is approximately 10%. The following description is made by taking an example in which the threshold doping concentration is 10%.

Regarding the influence of the doping concentration of the n-type charge generation layer 31 and the doping concentration of the p-type charge generation layer 32 in the charge generation stack layer 30 on the undesired peaks of the light emitted by the light-emitting device O, as shown in FIGS. 24 to 26, in the case where the doping concentration of the second foreign substance in the p-type charge generation layer 32 is set to be less than the threshold doping concentration (that is, the doping concentration of the second foreign substance in the p-type charge generation layer 32 is set to be less than 10%), the doping concentration of the first foreign substance in the n-type charge generation layer 31 is adjusted to make the doping concentration of the first foreign substance in the n-type charge generation layer 31 float within a range of 0.5% to 2% for experiments.

Specifically, in a case where the doping concentration of the second foreign substance in the p-type charge generation layer 32 is approximately 5%, a spectrum when the doping concentration of the first foreign substance in the n-type charge generation layer 31 is approximately 0.5%, a spectrum when the doping concentration of the first foreign substance in the n-type charge generation layer 31 is approximately 1%, and a spectrum when the doping concentration of the first foreign substance in the n-type charge generation layer 31 is approximately 2% are illustrated.

As shown in FIGS. 24 to 26, in the case where the doping concentration of the second foreign substance in the p-type charge generation layer 32 is approximately 5%, the doping concentration of the first foreign substance in the n-type charge generation layer 31 is in a range of 0.5% to 2%; the proportion of undesired peaks of light emitted by the light-emitting device O corresponding to the doping concentration of 0.5%, the proportion of undesired peaks of light emitted by the light-emitting device O corresponding to the doping concentration of 1%, and the proportion of undesired peaks of light emitted by the light-emitting device O corresponding to the doping concentration of 2%, sequentially decrease; that is, when the doping concentration of the second foreign substance in the p-type charge generation layer 32 is less than the threshold doping concentration, the higher the doping concentration of the first foreign substance in the n-type charge generation layer 31 is, the smaller the proportion of undesired peaks of light emitted by the light-emitting device O will be; therefore, the color cast of the display substrate 100 may be ameliorated to a great extent.

As shown in FIGS. 24 to 26, in the light-emitting device O emitting light of any color, when the doping concentration of the second foreign substance in the p-type charge generation layer 32 is less than the threshold doping concentration, the higher the doping concentration of the first foreign substance in the n-type charge generation layer 31 is, the better the proportion of undesired peaks of light emitted by the light-emitting device O will be reduced, so as to ameliorate the color cast of the display substrate 100 to a great extent.

In summary, in the case where the doping concentration of the first foreign substance in the n-type charge generation layer 31 is in a range of 0.5% to 2% and the doping concentration of the second foreign substance in the p-type charge generation layer 32 is in a range of 5% to 15%, when the doping concentration of the second foreign substance in the p-type charge generation layer 32 is low (less than 10%) and the doping concentration of the first foreign substance in the n-type charge generation layer 31 is high (equal to or close to 2%), in the charge generation stack layer 30, the p-type charge generation layer 32 has a small amount of holes and a weak ability to attract electrons, that is, the space charge region (the region at the interface between the n-type charge generation layer 31 and the p-type charge generation layer 32) has a small amount of electrons. In this case, since the highly doped n-type charge generation layer 31 has a large amount of electrons, a concentration of electrons in the n-type charge generation layer 31 and a concentration of electrons in the space charge region have a concentration difference. Therefore, the electrons in the n-type charge generation layer 31 may move toward the space charge region which is close to the p-type charge generation layer 32 to supplement the amount of electrons in the space charge region. Furthermore, the space charge region in the charge generation stack layer 30 may make the PN junction stable.

Based on this, holes in the space charge region will move upward and recombine with electrons in the second light-emitting unit 40 (provided by the second electrode 50) to form excitons, and electrons in the space charge region will move downward and recombine with holes in the first light-emitting unit 20 (provided by the first electrode 10) to form excitons. The more the quantities of holes and electrons in the two light-emitting units (the first light-emitting unit 20 and the second light-emitting unit 40) match, the lower the chance of the crosstalk caused by lateral transport of holes and electrons is. That is, the formed charge generation stack layer 30 may amlieorate the lateral transport of holes and electrons in the charge generation stack layer 30 to a great extent, so as to solve the color cast of the display substrate 100.

In some examples, the n-type charge generation layer 31 is the first-kind n-type charge generation layer, the doping concentration of the first foreign substance in the first-kind n-type charge generation layer is approximately 2%, and the doping concentration of the second foreign substance in the p-type charge generation layer 32 is less than the threshold doping concentration (the doping concentration is in a range of 5% to 10%); in this case, the lateral resistance of the formed charge generation stack layer 30 is in a range of 150 GΩ/µm² to 210 GΩ/µm². That is, the lateral resistance of the charge generation stack layer 30 may be made greater, so that the charge generation stack layer 30 may effectively suppress the lateral transport of the holes and electrons in the charge generation stack layer 30 to adjacent light-emitting devices O, which ameliorates the color cast of the display substrate 100 and improves the display quality of the display substrate 100.

For example, the p-type charge generation layer 32 is the first-kind p-type charge generation layer, and the lateral resistance of the formed charge generation stack layer 30 is in a range of 160 GΩ/µm² to 210 GΩ/µm².

For example, the p-type charge generation layer 32 is the second-kind p-type charge generation layer, and the lateral resistance of the formed charge generation stack layer 30 is in a range of 150 GΩ/µm² to 190 GΩ/µm².

In summary, in the case where the n-type charge generation layer 31 is the first-kind n-type charge generation layer and the doping concentration of the first foreign substance in the first-kind n-type charge generation layer is approximately 2%, when the p-type charge generation layer 32 is the first-kind p-type charge generation layer and the doping concentration of the second foreign substance in the first-kind p-type charge generation layer is less than the threshold doping concentration (the doping concentration is in a range of 5% to 10%), the lateral resistance of the formed charge generation stack layer 30 may be made greater, so that the color cast of the display substrate 100 may be ameliorated to a great extent, and the display quality of the display substrate 100 is improved. However, the embodiments of the present disclosure are not limited thereto.

In some examples, when the doping concentration of the first foreign substance in the n-type charge generation layer 31 is in a range of 1% to 2%, the doping concentration of the second foreign substance in the p-type charge generation layer 32 is in a range of 5% to 10%.

That is, when the doping concentration of the second foreign substance in the first-kind p-type charge generation layer is less than the threshold doping concentration (the doping concentration is in a range of 5% to 10%), a highly doped n-type charge generation layer 31 may be selected, that is, an n-type charge generation layer 31 that the doping concentration of the first foreign substance is in a range of 1% to 2% may be selected.

Based on this, the charge generation stack layer 30 may form a PN junction, and the lateral resistance of the formed charge generation stack layer 30 may be made greater, so that the color cast of the display substrate 100 may be ameliorated to a great extent, and the display quality of the display substrate 100 is improved. However, the embodiments of the present disclosure are not limited thereto.

In some examples, regarding the influence of the doping concentration of the n-type charge generation layer 31 and the doping concentration of the p-type charge generation layer 32 in the charge generation stack layer 30 on the undesired peaks of the light emitted by the light-emitting device O, as shown in FIGS. 27 to 29, in the case where the doping concentration of the second foreign substance in the p-type charge generation layer 32 is set to be greater than or equal to the threshold doping concentration (that is, the doping concentration of the second foreign substance in the p-type charge generation layer 32 is set to be greater than or equal to 10%), the doping concentration of the first foreign substance in the n-type charge generation layer 31 is adjusted to make the doping concentration of the first foreign substance in the n-type charge generation layer 31 float within a range of 0.5% to 2% for experiments.

Specifically, in a case where the doping concentration of the second foreign substance in the p-type charge generation layer 32 is approximately 10%, a spectrum when the doping concentration of the first foreign substance in the n-type charge generation layer 31 is approximately 0.5% and a spectrum when the doping concentration of the first foreign substance in the n-type charge generation layer 31 is approximately 1% are illustrated.

As shown in FIGS. 27 to 29, in the case where the doping concentration of the second foreign substance in the p-type charge generation layer 32 is approximately 10%, the doping concentration of the first foreign substance in the n-type charge generation layer 31 is in a range of 0.5% to 2%; the proportion of undesired peaks of light emitted by the light-emitting device O corresponding to the doping concentration of 0.5% and the proportion of undesired peaks of light emitted by the light-emitting device O corresponding to the doping concentration of 1% sequentially decrease; that is, when the doping concentration of the second foreign substance in the p-type charge generation layer 32 is greater than or equal to the threshold doping concentration, the higher the doping concentration of the first foreign substance in the n-type charge generation layer 31 is, the smaller the proportion of undesired peaks of light emitted by the light-emitting device O will be; therefore, the color cast of the display substrate 100 may be ameliorated to a great extent.

In the case where the doping concentration of the first foreign substance in the n-type charge generation layer 31 is in a range of 0.5% to 2% and the doping concentration of the second foreign substance in the p-type charge generation layer 32 is in a range of 5% to 15%, when the doping concentration of the second foreign substance in the p-type charge generation layer 32 is high (greater than or equal to 10%) and the doping concentration of the first foreign substance in the n-type charge generation layer 31 is low (equal to or close to 0.5%), in the charge generation stack layer 30, the p-type charge generation layer 32 has a large amount of holes and a strong ability to attract electrons, that is, the space charge region (the region at the interface between the n-type charge generation layer 31 and the p-type charge generation layer 32) has a large amount of electrons and a small amount of holes. In this case, since the highly doped p-type charge generation layer 32 has a large amount of holes, a concentration of holes in the p-type charge generation layer 32 and a concentration of holes in the space charge region have a concentration difference. Therefore, the holes in the p-type charge generation layer 32 may move toward the space charge region which is close to the n-type charge generation layer 31 to supplement the amount of holes in the space charge region. Furthermore, the space charge region in the charge generation stack layer 30 may make the PN junction stable.

Based on this, holes in the space charge region will move upward and recombine with electrons in the second light-emitting unit 40 (provided by the second electrode 50) to form excitons, and electrons in the space charge region will move downward and recombine with holes in the first light-emitting unit 20 (provided by the first electrode 10) to form excitons. The more the quantities of holes and electrons in the two light-emitting units (the first light-emitting unit 20 and the second light-emitting unit 40) match, the lower the chance of the crosstalk caused by lateral transport of holes and electrons is. That is, the formed charge generation stack layer 30 may amlieorate the lateral transport of holes and electrons in the charge generation stack layer 30 to a great extent and amlieorate the color cast of the display substrate 100 caused by the color crosstalk between adjacent light-emitting devices O in the display substrate 100.

For example, considering a high grayscale (255-grayscale) as an example for introduction, as shown in FIG. 27, the proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%; as shown in FIG. 28, the proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%; as shown in FIG. 29, the proportion of undesired peaks generated by the light-emitting device O in the third sub-pixel P3 (blue) due to the impact of the light-emitting device O in the first sub-pixel P1 (red) and the light-emitting device O in the second sub-pixel P2 (green) is approximately 0%.

That is, among the light-emitting device O in the first sub-pixel P1 (red), the light-emitting device O in the second sub-pixel P2 (green) and the light-emitting device O in the third sub-pixel P3 (blue), the proportion of undesired peaks generated by a light-emitting device O in one sub-pixel P due to the impact of light-emitting devices O in the other two sub-pixels P is approximately 0%.

In summary, in the light-emitting device O emitting light of any color, when the doping concentration of the second foreign substance in the p-type charge generation layer 32 is greater than or equal to the threshold doping concentration, the higher the doping concentration of the first foreign substance in the n-type charge generation layer 31 is, the smaller the proportion of undesired peaks of light emitted by the light-emitting device O will be; therefore, the color cast of the display substrate 100 may be ameliorated to a great extent.

In some examples, the n-type charge generation layer 31 is the first-kind n-type charge generation layer, the doping concentration of the first foreign substance in the first-kind n-type charge generation layer is approximately 0.5%, and the doping concentration of the second foreign substance in the p-type charge generation layer 32 is greater than or equal to the threshold doping concentration (the doping concentration is in a range of 10% to 15%); in this case, the lateral resistance of the formed charge generation stack layer 30 is in a range of 140 GΩ/µm² to 200 GΩ/µm². That is, the lateral resistance of the charge generation stack layer 30 may be made greater, so that the charge generation stack layer 30 may effectively suppress the lateral transport of the holes and electrons in the charge generation stack layer 30 to adjacent light-emitting devices O, which ameliorates the color cast of the display substrate 100 and improves the display quality of the display substrate 100.

For example, the p-type charge generation layer 32 is the first-kind p-type charge generation layer, and the lateral resistance of the formed charge generation stack layer 30 is in a range of 150 GΩ/µm² to 200 GΩ/µm².

For example, the p-type charge generation layer 32 is the second-kind p-type charge generation layer, and the lateral resistance of the formed charge generation stack layer 30 is in a range of 140 GΩ/µm² to 180 GΩ/µm².

In summary, in the case where the n-type charge generation layer 31 is the first-kind n-type charge generation layer and the doping concentration of the first foreign substance in the first-kind n-type charge generation layer is approximately 0.5%, when the p-type charge generation layer 32 is the first-kind p-type charge generation layer and the doping concentration of the second foreign substance in the first-kind p-type charge generation layer is greater than or equal to the threshold doping concentration (the doping concentration is in a range of 10% to 15%), the lateral resistance of the formed charge generation stack layer 30 may be made greater, so that the color cast of the display substrate 100 may be ameliorated to a great extent, and the display quality of the display substrate 100 is improved. However, the embodiments of the present disclosure are not limited thereto.

In some examples, when the doping concentration of the first foreign substance in the n-type charge generation layer 31 is in a range of 0.5% to 1%, the doping concentration of the second foreign substance in the p-type charge generation layer 32 is in a range of 10% to 15%.

That is, when the doping concentration of the second foreign substance in the first-kind p-type charge generation layer is greater than or equal to the threshold doping concentration (the doping concentration is in a range of 10% to 15%), a lightly doped n-type charge generation layer 31 may be selected, that is, an n-type charge generation layer 31 that the doping concentration of the first foreign substance is in a range of 0.5% to 1% may be selected.

Based on this, the charge generation stack layer 30 may form a PN junction, and the lateral resistance of the formed charge generation stack layer 30 may be made greater, so that the color cast of the display substrate 100 may be ameliorated to a great extent, and the display quality of the display substrate 100 is improved. However, the embodiments of the present disclosure are not limited thereto.

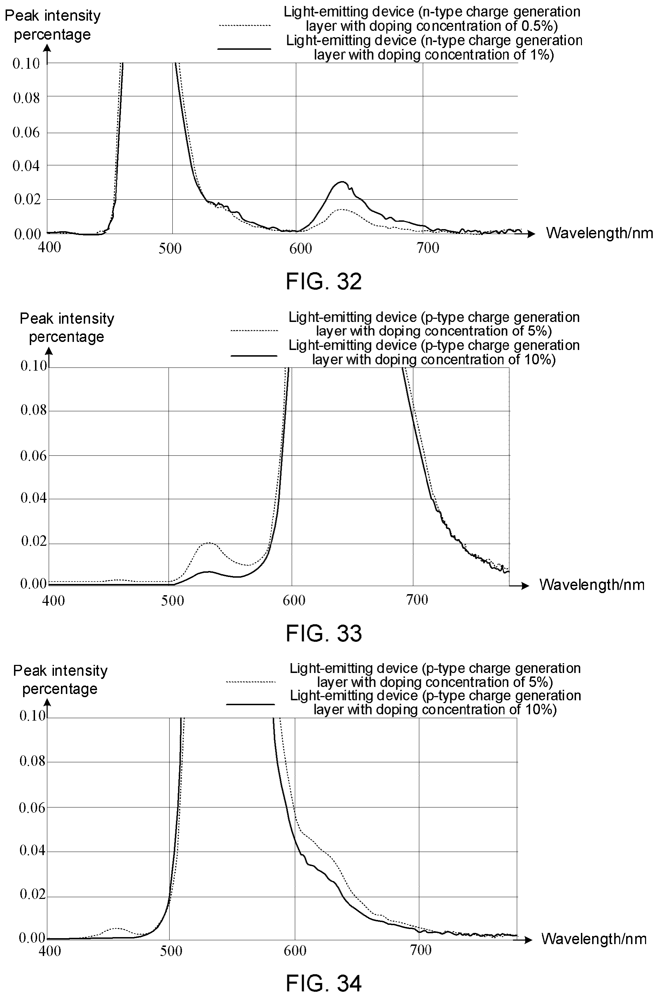

FIG. 30 is a spectrum diagram of a light-emitting device for emitting red light, in accordance with yet some other embodiments. FIG. 31 is a spectrum diagram of a light-emitting device for emitting green light, in accordance with yet some other embodiments. FIG. 32 is a spectrum diagram of a light-emitting device for emitting blue light, in accordance with yet some other embodiments. FIGS. 30 to 32 each illustrate an example in which the grayscale of the light-emitting device O in the display substrate 100 is a low grayscale (e.g., 8-grayscale).

The color cast of the display substrate 100 in a low grayscale state is more obvious than the color cast of the display substrate 100 in a high grayscale state. Then, based on FIGS. 27 to 29, only the grayscale of the light-emitting device O was changed for experiments. Specifically, the grayscale of the light-emitting device O in the display substrate 100 as a low grayscale (e.g., 8-grayscale) is taken as an example for description.

As shown in FIGS. 30 to 32, it can be seen that in the low grayscale state, when the doping concentration of the second foreign substance in the p-type charge generation layer 32 is greater than or equal to the threshold doping concentration, the smaller the doping concentration of the first foreign substance in the n-type charge generation layer 31, the better. That is, when the doping concentration of the first foreign substance in the n-type charge generation layer 31 is in a range of 0.5% to 2% and the doping concentration is equal to or close to 0.5%, the proportion of undesired peaks of the light emitted by the light-emitting device O may be relatively smaller, which may be more conducive to ameliorating the color cast of the display substrate 100.

Specifically, as shown in FIG. 30, the proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%. As shown in FIG. 31, the proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%. As shown in FIG. 32, the proportion of undesired peaks generated by the light-emitting device O in the third sub-pixel P3 (blue) due to the impact of the light-emitting device O in the first sub-pixel P1 (red) is less than or equal to 3%; and the proportion of undesired peaks generated by the light-emitting device O in the third sub-pixel P3 (blue) due to the impact of the light-emitting device O in the second sub-pixel P2 (green) is less than or equal to 2.5%.

In summary, in the low grayscale state, the undesired peaks of the light-emitting device O emitting red light and the light-emitting device O emitting green light are basically removed, and the light-emitting device O emitting blue light still has undesired peaks to a certain extent. However, the proportion of undesired peaks of the light emitted by the light-emitting device O emitting blue light may be made less than 4%, and the color cast of the display substrate 100 may be ameliorated. In addition, in the light-emitting device O emitting light of any color, when the doping concentration of the second foreign substance in the p-type charge generation layer 32 is greater than or equal to the threshold doping concentration and the doping concentration is equal to or close to 0.5%, the color cast of the display substrate 100 may be ameliorated to a great extent. The light-emitting device O emitting blue light shown in FIG. 32 is particularly clear. A doping ratio between the n-type charge generation layer 31 and the p-type charge generation layer may be further adjusted to further improve the effect of ameliorating the color cast of the display substrate 100.

With reference to Table 2 and FIGS. 27 to 32, it can be seen that when the doping concentration of the n-type charge generation layer varies, color coordinates at 255-grayscale and 8-grayscale have small difference, which may be conducive to improving the effect of ameliorating the color cast of the display substrate 100.

**Table 2 shows difference between color coordinates at 255-grayscale and 8-grayscale at different doping concentrations of n-type charge generation layer**

| | Difference | |
|---|---|---|
| | Doping concentration of the first foreign substance in the n-type charge generation layer 31 is 0.5% | Doping concentration of the first foreign substance in the n-type charge generation layer 31 is 1% |
| Light-emitting device O emitting red light | 0.001 | 0.001 |
| Light-emitting device O emitting green light | 0.002 | 0.003 |
| Light-emitting device O emitting blue light | 0.009 | 0.016 |

For the light-emitting device O emitting red light and the light-emitting device O emitting green light, difference on the X-axis (X-coordinate in color coordinates) is determined. For the light-emitting device O emitting blue light, difference on the Y-axis (Y-coordinate in color coordinates) is determined.

With reference to relevant accompanying drawings, the above description introduces that "some other parameters" may include the doping concentration of the charge generation layer in the charge generation stack layer 30. Then, the following description mainly introduces that "some other parameters" may further include a relationship between the doping concentration of the charge generation layer and a material of the charge generation layer.

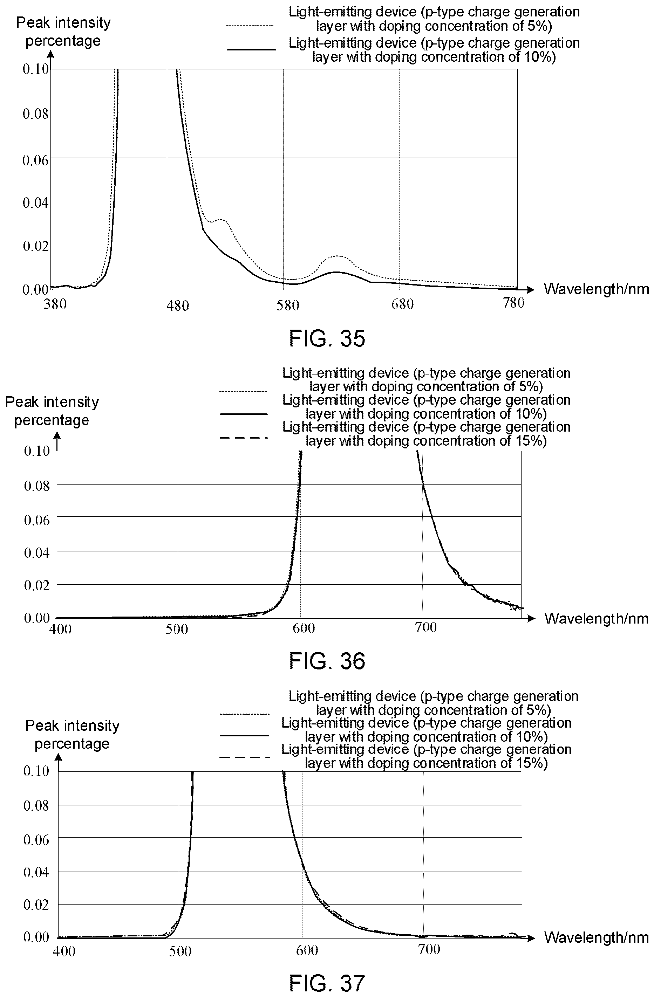

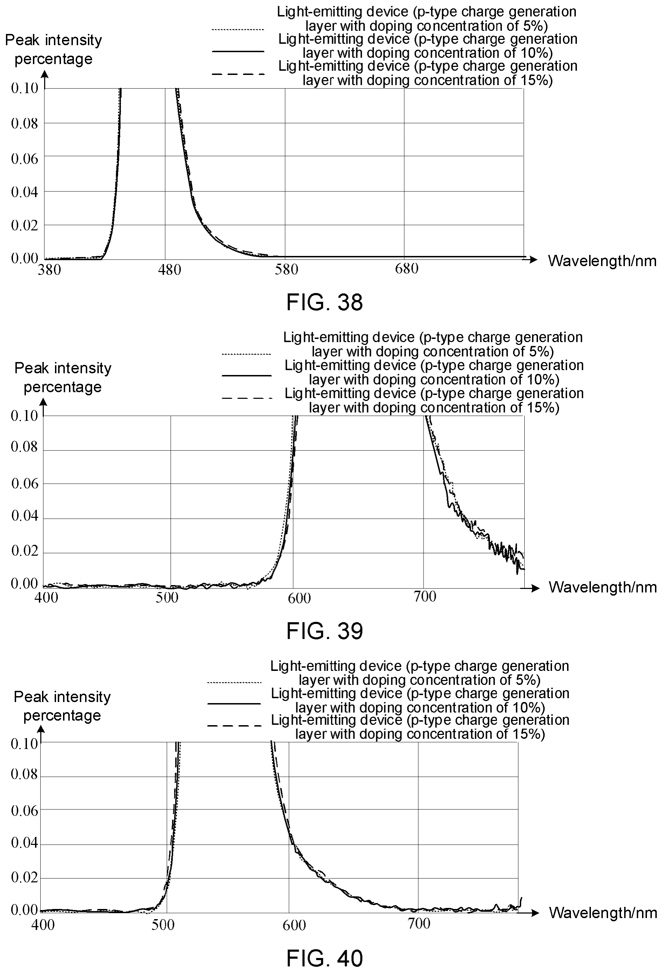

FIG. 33 is a spectrum diagram of a light-emitting device for emitting red light, in accordance with yet some other embodiments. FIG. 34 is a spectrum diagram of a light-emitting device for emitting green light, in accordance with yet some other embodiments. FIG. 35 is a spectrum diagram of a light-emitting device for emitting blue light, in accordance with yet some other embodiments. FIGS. 33 to 35 each illustrate an example in which the grayscale of the light-emitting device O in the display substrate 100 is a high grayscale (e.g., 255-grayscale) and the n-type charge generation layer 31 is the second-kind n-type charge generation layer. FIG. 36 is a spectrum diagram of a light-emitting device for emitting red light, in accordance with yet some other embodiments. FIG. 37 is a spectrum diagram of a light-emitting device for emitting green light, in accordance with yet some other embodiments. FIG. 38 is a spectrum diagram of a light-emitting device for emitting blue light, in accordance with yet some other embodiments. FIGS. 36 to 38 each illustrate an example in which the grayscale of the light-emitting device O in the display substrate 100 is a high grayscale (e.g., 255-grayscale) and the n-type charge generation layer 31 is the first-kind n-type charge generation layer.

The difference between the spectra shown in FIGS. 36 to 38 and the spectra shown in FIGS. 33 to 35 is that: the n-type charge generation layers 31 in the light-emitting devices O corresponding to the spectra shown in FIGS. 36 to 38 are first-kind n-type charge generation layers, and the n-type charge generation layers 31 in the light-emitting devices O corresponding to the spectra shown in FIGS. 33 to 35 are second-kind n-type charge generation layers.

In some embodiments, as shown in FIGS. 14 and 33 to 38, the lateral resistance of the n-type charge generation layer 31 is negatively correlated with the doping concentration of the second foreign substance in the p-type charge generation layer 32.

The description "the lateral resistance of the n-type charge generation layer 31 is negatively correlated with the doping concentration of the second foreign substance in the p-type charge generation layer 32" can be understood as, the n-type charge generation layer 31 may include the first-kind n-type charge generation layer and the second-kind n-type charge generation layer, and the lateral resistance of the first-kind n-type charge generation layer is greater than the lateral resistance of the second-kind n-type charge layer; therefore, when the n-type charge generation layer 31 is the first-kind n-type charge generation layer, the lower the doping concentration of the second foreign substance in the p-type charge generation layer 32, the better the effect of ameliorating the color cast of the display substrate 100; and when the n-type charge generation layer 31 is the second-kind n-type charge generation layer, the higher the doping concentration of the second foreign substance in the p-type charge generation layer 32, the better the effect of ameliorating the color cast of the display substrate 100.

In some examples, regarding the influence of the doping concentration of the second foreign substance in the p-type charge generation layer 32 on the undesired peaks of the light emitted by the light-emitting device O when the n-type charge generation layer 31 is the second-kind n-type charge generation layer, as shown in FIGS. 33 to 35, when the n-type charge generation layer 31 is the second-kind n-type charge generation layer, the doping concentration of the second foreign substance in the p-type charge generation layer 32 is adjusted to make the doping concentration of the second foreign substance in the p-type charge generation layer 32 float within a range of 5% to 15% for experiments.

Specifically, in a case where the n-type charge generation layer 31 is the second-kind n-type charge generation layer, a spectrum when the doping concentration of the second foreign substance in the p-type charge generation layer 32 is approximately 5% and a spectrum when the doping concentration of the second foreign substance in the p-type charge generation layer 32 is approximately 10% are illustrated.

As shown in FIGS. 33 to 35, in the case where the n-type charge generation layer 31 is the second-kind n-type charge generation layer, the proportion of undesired peaks of light emitted by the light-emitting device O when the doping concentration of the second foreign substance in the p-type charge generation layer 32 is 5% and the proportion of undesired peaks of light emitted by the light-emitting device O when the doping concentration of the second foreign substance in the p-type charge generation layer 32 is 10% sequentially decrease. That is, in the case where the n-type charge generation layer 31 is the second-kind n-type charge generation layer with a small lateral resistance, the higher the doping concentration of the second foreign substance in the p-type charge generation layer 31 is, the smaller the proportion of undesired peaks of light emitted by the light-emitting device O will be; therefore, the color cast of the display substrate 100 may be ameliorated to a great extent.

In addition, as shown in FIGS. 33 to 35, in the light-emitting device O emitting light of any color, in the case where the n-type charge generation layer 31 is the second-kind n-type charge generation layer, the higher the doping concentration of the second foreign substance in the p-type charge generation layer 31 is, the smaller the proportion of undesired peaks of light emitted by the light-emitting device O will be; therefore, the color cast of the display substrate 100 may be ameliorated to a great extent.

In summary, in the case where the n-type charge generation layer 31 is the second-kind n-type charge generation layer and the doping concentration of the second foreign substance in the p-type charge generation layer 32 is in a range of 5% to 15%:

Since the lateral resistance of the second-kind n-type charge generation layer is smaller (relative to the first-kind n-type charge generation layer), the electrons in the second-kind n-type charge generation layer are prone to lateral transport, which in turn leads to a small amount of electrons in the second-kind n-type charge generation layer. Since the second-kind n-type charge generation layer has a small amount of electrons, it has a weaker ability to attract holes, which results in a small amount of holes in the space charge region (the region at the interface between the n-type charge generation layer 31 and the p-type charge generation layer 32). In this case, a p-type charge generation layer 32 with a higher doping concentration is selected, so that the amount of holes in the p-type charge generation layer 32 may be made greater. Furthermore, the holes in the p-type charge generation layer 32 and the holes in the space charge region may have a concentration difference, so that the holes in the p-type charge generation layer 32 may move toward the space charge region close to the n-type charge generation layer 31 to supplement the amount of holes in the space charge region. Thus, the space charge region in the charge generation stack layer 30 may make the PN junction stable.

Based on this, holes in the space charge region will move upward and recombine with electrons in the second light-emitting unit 40 (provided by the second electrode 50) to form excitons, and electrons in the space charge region will move downward and recombine with holes in the first light-emitting unit 20 (provided by the first electrode 10) to form excitons. The more the quantities of holes and electrons in the two light-emitting units (the first light-emitting unit 20 and the second light-emitting unit 40) match, the lower the chance of the crosstalk caused by lateral transport of holes and electrons is. That is, the formed charge generation stack layer 30 may amlieorate the lateral transport of holes and electrons in the charge generation stack layer 30 to a great extent, so as to solve the color cast of the display substrate 100.

In some examples, regarding the influence of the doping concentration of the second foreign substance in the p-type charge generation layer 32 on the undesired peaks of the light emitted by the light-emitting device O when the n-type charge generation layer 31 is the first-kind n-type charge generation layer, as shown in FIGS. 36 to 38, when the n-type charge generation layer 31 is the first-kind n-type charge generation layer, the doping concentration of the second foreign substance in the p-type charge generation layer 32 is adjusted to make the doping concentration of the second foreign substance in the p-type charge generation layer 32 float within a range of 5% to 15% for experiments.

Specifically, in a case where the n-type charge generation layer 31 is the first-kind n-type charge generation layer, a spectrum when the doping concentration of the second foreign substance in the p-type charge generation layer 32 is approximately 5%, a spectrum when the doping concentration of the second foreign substance in the p-type charge generation layer 32 is approximately 10%, and a spectrum when the doping concentration of the second foreign substance in the p-type charge generation layer 32 is approximately 15% are illustrated.

As shown in FIGS. 36 to 38, in the case where the n-type charge generation layer 31 is the first-kind n-type charge generation layer, the proportion of undesired peaks of light emitted by the light-emitting device O when the doping concentration of the second foreign substance in the p-type charge generation layer 32 is 15%, the proportion of undesired peaks of light emitted by the light-emitting device O when the doping concentration of the second foreign substance in the p-type charge generation layer 32 is 10%, and the proportion of undesired peaks of light emitted by the light-emitting device O when the doping concentration of the second foreign substance in the p-type charge generation layer 32 is 5% sequentially decrease. That is, in the case where the n-type charge generation layer 31 is the first-kind n-type charge generation layer with a small lateral resistance, the lower the doping concentration of the second foreign substance in the p-type charge generation layer 31 is, the smaller the proportion of undesired peaks of light emitted by the light-emitting device O will be; therefore, the color cast of the display substrate 100 may be ameliorated to a great extent.

In addition, as shown in FIGS. 36 to 38, in the light-emitting device O emitting light of any color, in the case where the n-type charge generation layer 31 is the first-kind n-type charge generation layer, the lower the doping concentration of the second foreign substance in the p-type charge generation layer 31 is, the smaller the proportion of undesired peaks of light emitted by the light-emitting device O will be; therefore, the color cast of the display substrate 100 may be ameliorated to a great extent.

In summary, in the case where the n-type charge generation layer 31 is the first-kind n-type charge generation layer and the doping concentration of the second foreign substance in the p-type charge generation layer 32 is in a range of 5% to 15%: since the lateral resistance of the first-kind n-type charge generation layer is larger (relative to the second-kind n-type charge generation layer), the electrons in the first-kind n-type charge generation layer are not prone to lateral transport, which in turn leads to a large amount of electrons in the first-kind n-type charge generation layer. Since the first-kind n-type charge generation layer has a large amount of electrons, it has a stronger ability to attract holes, which results in a large amount of holes and a small amount of electrons in the space charge region (the region at the interface between the n-type charge generation layer 31 and the p-type charge generation layer 32). In this case, a p-type charge generation layer 32 with a lower doping concentration is selected, so that the amount of holes in the p-type charge generation layer 32 may be made smaller. Furthermore, the holes in the p-type charge generation layer 32 and the holes in the space charge region may have a concentration difference, so that the holes in the space charge region may move toward the p-type charge generation layer 32. In addition, the electrons in the n-type charge generation layer 31 and the electrons in the space charge region may have a concentration difference, so that the electrons in the n-type charge generation layer 31 may move toward the space charge region. Based on this, the amount of electrons and the amount of holes in the space charge region may be balanced, and the space charge region in the charge generation stack layer 30 may make the PN junction stable.

Based on this, holes in the space charge region will move upward and recombine with electrons in the second light-emitting unit 40 (provided by the second electrode 50) to form excitons, and electrons in the space charge region will move downward and recombine with holes in the first light-emitting unit 20 (provided by the first electrode 10) to form excitons. The more the quantities of holes and electrons in the two light-emitting units (the first light-emitting unit 20 and the second light-emitting unit 40) match, the lower the chance of the crosstalk caused by lateral transport of holes and electrons is. That is, the formed charge generation stack layer 30 may amlieorate the lateral transport of holes and electrons in the charge generation stack layer 30 to a great extent, so as to solve the color cast of the display substrate 100.

For example, considering a high grayscale (255-grayscale) as an example for introduction, as shown in FIG. 36, the proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%; as shown in FIG. 37, the proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%; as shown in FIG. 38, the proportion of undesired peaks generated by the light-emitting device O in the third sub-pixel P3 (blue) due to the impact of the light-emitting device O in the first sub-pixel P1 (red) and the light-emitting device O in the second sub-pixel P2 (green) is approximately 0%.

That is, among the light-emitting device O in the first sub-pixel P1 (red), the light-emitting device O in the second sub-pixel P2 (green) and the light-emitting device O in the third sub-pixel P3 (blue), the proportion of undesired peaks generated by a light-emitting device O in one sub-pixel P due to the impact of light-emitting devices O in the other two sub-pixels P is approximately 0%.

In summary, in the light-emitting device O emitting light of any color, in the case where the n-type charge generation layer 31 is the first-kind n-type charge generation layer, the lower the doping concentration of the second foreign substance in the p-type charge generation layer 31 is, the smaller the proportion of undesired peaks of light emitted by the light-emitting device O will be; therefore, the color cast of the display substrate 100 may be ameliorated to a great extent.

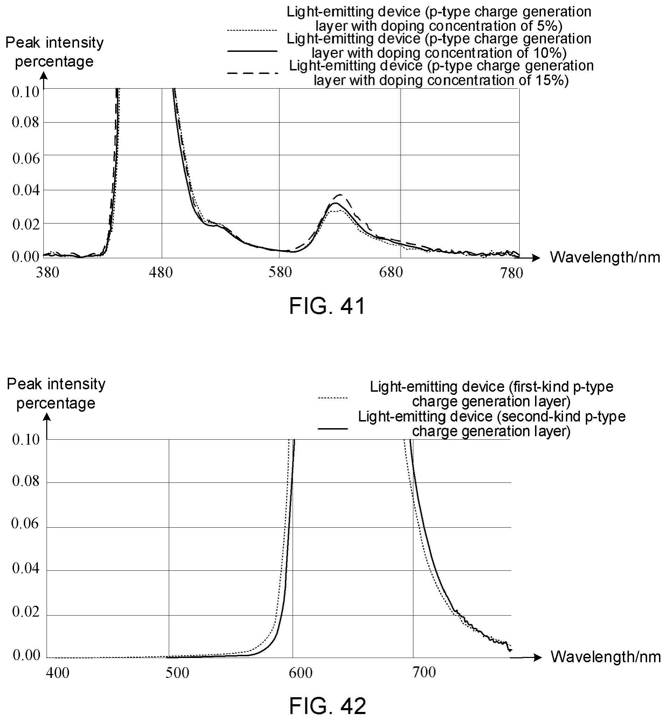

FIG. 39 is a spectrum diagram of a light-emitting device for emitting red light, in accordance with yet some other embodiments. FIG. 40 is a spectrum diagram of a light-emitting device for emitting green light, in accordance with yet some other embodiments. FIG. 41 is a spectrum diagram of a light-emitting device for emitting blue light, in accordance with yet some other embodiments.

FIGS. 39 to 41 each illustrate an example in which the grayscale of the light-emitting device O in the display substrate 100 is a low grayscale (e.g., 8-grayscale) and the n-type charge generation layer 31 is the first-kind n-type charge generation layer.

The color cast of the display substrate 100 in a low grayscale state is more obvious than the color cast of the display substrate 100 in a high grayscale state. Then, based on FIGS. 36 to 38, only the grayscale of the light-emitting device O was changed for experiments. Specifically, the grayscale of the light-emitting device O in the display substrate 100 as a low grayscale (e.g., 8-grayscale) is taken as an example for description.

As shown in FIGS. 39 to 41, it can be seen that in the low grayscale state, in the case where the n-type charge generation layer 31 is the first-kind n-type charge generation layer, the lower the doping concentration of the second foreign substance in the p-type charge generation layer 31 is, the smaller the proportion of undesired peaks of light emitted by the light-emitting device O will be; therefore, the color cast of the display substrate 100 may be ameliorated to a great extent.

That is, in the case where the n-type charge generation layer 31 is the first-kind n-type charge generation layer, when the doping concentration of the second foreign substance in the p-type charge generation layer 31 is in a range of 5% to 15% and the doping concentration is equal to or close to 5%, the proportion of undesired peaks of light emitted by the light-emitting device O may be relatively smaller, which may be more conducive to ameliorating the color cast of the display substrate 100.

Specifically, as shown in FIG. 39, the proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%.

As shown in FIG. 40, the proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%.

As shown in FIG. 41, the proportion of undesired peaks generated by the light-emitting device O in the third sub-pixel P3 (blue) due to the impact of the light-emitting device O in the first sub-pixel P1 (red) is less than or equal to 3.5%; and the proportion of undesired peaks generated by the light-emitting device O in the third sub-pixel P3 (blue) due to the impact of the light-emitting device O in the second sub-pixel P2 (green) is less than or equal to 3%.

In summary, in the low grayscale state, the undesired peaks of the light-emitting device O emitting red light and the light-emitting device O emitting green light are basically removed, and the light-emitting device O emitting blue light still has undesired peaks to a certain extent. However, the proportion of undesired peaks of the light emitted by the light-emitting device O emitting blue light may be made less than 4%, and the color cast of the display substrate 100 may be ameliorated.

In addition, in the light-emitting device O emitting light of any color, in the case where the n-type charge generation layer 31 is the first-kind n-type charge generation layer, when the doping concentration of the second foreign substance in the p-type charge generation layer 31 is equal to or close to 5%, the color cast of the display substrate 100 may be ameliorated to a great extent.

The light-emitting device O emitting blue light shown in FIG. 41 is particularly clear. A relationship between the lateral resistance of the n-type charge generation layer 31 and the doping concentration of the p-type charge generation layer may be further adjusted to further improve the effect of ameliorating the color cast of the display substrate 100.

With reference to Table 3 and FIGS. 27 to 32, it can be seen that when the doping concentration of the p-type charge generation layer varies, color coordinates at 255-grayscale and 8-grayscale have small difference, which may be conducive to improving the effect of ameliorating the color cast of the display substrate 100.

In the following Table 3, for the light-emitting device O emitting red light and the light-emitting device O emitting green light, difference on the X-axis (X-coordinate in color coordinates) is determined. For the light-emitting device O emitting blue light, difference on the Y-axis (Y-coordinate in color coordinates) is determined.

**Table 3 shows difference between color coordinates at 255-grayscale and 8-grayscale at different doping concentrations of p-type charge generation layer**

| | Difference | | |
|---|---|---|---|
| | Doping concentration of the p-type charge generation layer is 5% | Doping concentration of the p-type charge generation layer is 10% | Doping concentration of the p-type charge generation layer is 15% |
| Light-emitting device O emitting red light | 0.001 | 0.001 | 0.001 |
| Light-emitting device O emitting green light | 0.003 | 0.003 | 0.003 |
| Light-emitting device O emitting blue light | 0.016 | 0.017 | 0.019 |

In some examples, the lateral resistance of the charge generation stack layer 30 is negatively correlated with the doping concentration of the second foreign substance in the p-type charge generation layer 32. The description "the lateral resistance of the charge generation stack layer 30 is negatively correlated with the doping concentration of the second foreign substance in the p-type charge generation layer 32" can be understood as the following content, on the basis that the lateral resistance of the charge generation stack layer 30 is in a range of 100 GΩ/µm² to 260 GΩ/µm²:

For example, when the lateral resistance of the charge generation stack layer 30 is in a range of 180 GΩ/µm² to 260 GΩ/µm², the doping concentration of the second foreign substance in the p-type charge generation layer 32 is in a range of 5% to 10%.

When the lateral resistance of the charge generation stack layer 30 is greater than 180 GΩ/µm², the lateral resistance of the charge generation stack layer 30 takes a large value in a range of 180 GΩ/µm² to 260 GΩ/µm². In this case, a p-type charge generation layer 32 with a lower doping concentration of the second foreign substance may be selected, so that the n-type charge generation layer 31 may supplement the amount of electrons of the space charge region in the charge generation stack layer 30. Thus, the space charge region in the charge generation stack layer 30 may make the PN junction stable.

Based on this, holes in the space charge region will move upward and recombine with electrons in the second light-emitting unit 40 (provided by the second electrode 50) to form excitons, and electrons in the space charge region will move downward and recombine with holes in the first light-emitting unit 20 (provided by the first electrode 10) to form excitons. The more the quantities of holes and electrons in the two light-emitting units (the first light-emitting unit 20 and the second light-emitting unit 40) match, the lower the chance of the crosstalk caused by lateral transport of holes and electrons is. That is, the formed charge generation stack layer 30 may amlieorate the lateral transport of holes and electrons in the charge generation stack layer 30 to a great extent, so as to solve the color cast of the display substrate 100.

For example, when the lateral resistance of the charge generation stack layer 30 is in a range of 100 GΩ/µm² to 180 GΩ/µm², the doping concentration of the second foreign substance in the p-type charge generation layer 32 is in a range of 10% to 15%.

When the lateral resistance of the charge generation stack layer 30 is less than 180 GΩ/µm², the lateral resistance value of the charge generation stack layer 30 takes a small value in a range of 180 GΩ/µm² to 260 GΩ/µm². In this case, a p-type charge generation layer 32 with a higher doping concentration of the second foreign substance may be selected, so that the p-type charge generation layer 32 may supplement the amount of holes of the space charge region in the charge generation stack layer 30. Thus, the space charge region in the charge generation stack layer 30 may make the PN junction stable.

Based on this, holes in the space charge region will move upward and recombine with electrons in the second light-emitting unit 40 (provided by the second electrode 50) to form excitons, and electrons in the space charge region will move downward and recombine with holes in the first light-emitting unit 20 (provided by the first electrode 10) to form excitons. The more the quantities of holes and electrons in the two light-emitting units (the first light-emitting unit 20 and the second light-emitting unit 40) match, the lower the chance of the crosstalk caused by lateral transport of holes and electrons is. That is, the formed charge generation stack layer 30 may amlieorate the lateral transport of holes and electrons in the charge generation stack layer 30 to a great extent, so as to solve the color cast of the display substrate 100.

The above embodiments introduce, with reference to relevant drawings, how to adjust the characteristics of the n-type charge generation layer 31 or how to make the n-type charge generation layer 31 and the p-type charge generation layer 32 cooperate with each other to reduce the undesired peaks of the light emitted by the light-emitting device O and ameliorate the color cast of the display substrate 100. The following description will mainly introduce and verify, with reference to relevant drawings, whether a single p-type charge generation layer 32 reduces the undesired peaks of the light emitted by the light-emitting device O.

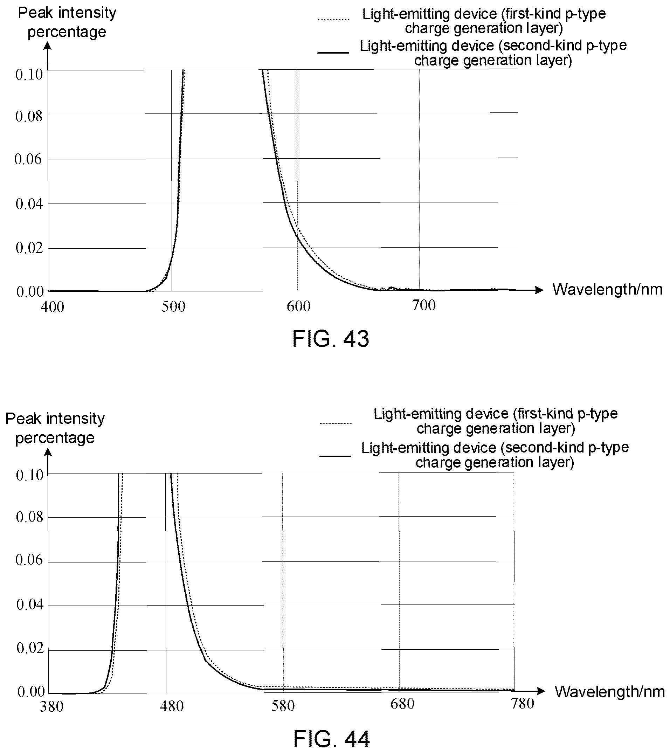

FIG. 42 is a spectrum diagram of a light-emitting device for emitting red light, in accordance with yet some other embodiments. FIG. 43 is a spectrum diagram of a light-emitting device for emitting green light, in accordance with yet some other embodiments. FIG. 44 is a spectrum diagram of a light-emitting device for emitting blue light, in accordance with yet some other embodiments. FIGS. 42 to 44 each illustrate an example in which the grayscale of the light-emitting device O in the display substrate 100 is a high grayscale (e.g., 255-grayscale) and the n-type charge generation layer 31 is the first-kind n-type charge generation layer.

In some embodiments, as shown in FIGS. 42 to 44, the p-type charge generation layer 31 includes a first-kind p-type charge generation layer and a second-kind p-type charge generation layer. A lateral resistance of the first-kind p-type charge generation layer is greater than a lateral resistance of the second-kind p-type charge generation layer.

In the case where the n-type charge generation layer 31 is the first-kind n-type charge generation layer, the first-kind n-type charge generation layer and the p-type charge generation layer (the first-kind p-type charge generation layer or the second-kind p-type charge generation layer) constitute the charge generation layer 31, and the lateral resistance of the charge generation stack layer 30 may be in a range of 100 GΩ/µm² to 260 GΩ/µm². Therefore, the charge generation stack layer 30 may effectively suppress the lateral transport of the holes and electrons in the charge generation stack layer 30 to adjacent light-emitting devices O and ameliorate the color cast of the display substrate 100; in addition, it may also prevent the life of the formed light-emitting device O from being affected.

With continued reference to FIGS. 42 to 44, since the lateral resistance of the first-kind p-type charge generation layer is greater than the lateral resistance of the second-kind p-type charge generation layer, when the first-kind p-type charge generation layer is used, the lateral resistance of the charge generation stack layer 30 may be relatively large, which may be conducive to reducing the lateral leakage current generated in the charge generation stack layer 30 and in turn ameliorating the color cast of the display substrate 100 to a great extent.

For example, considering a high grayscale (255-grayscale) as an example for introduction, as shown in FIG. 42, the proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%; as shown in FIG. 43, the proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%; as shown in FIG. 44, the proportion of undesired peaks generated by the light-emitting device O in the third sub-pixel P3 (blue) due to the impact of the light-emitting device O in the first sub-pixel P1 (red) and the light-emitting device O in the second sub-pixel P2 (green) is approximately 0%.

That is, among the light-emitting device O in the first sub-pixel P1 (red), the light-emitting device O in the second sub-pixel P2 (green) and the light-emitting device O in the third sub-pixel P3 (blue), the proportion of undesired peaks generated by a light-emitting device O in one sub-pixel P due to the impact of light-emitting devices O in the other two sub-pixels P is approximately 0%.

In summary, no matter the p-type charge generation layer 31 is the first-kind p-type charge generation layer or the second-kind p-type charge generation layer, the proportion of undesired peaks of the light emitted by the light-emitting device O may be small, and the color cast of the display substrate 100 is ameliorated.

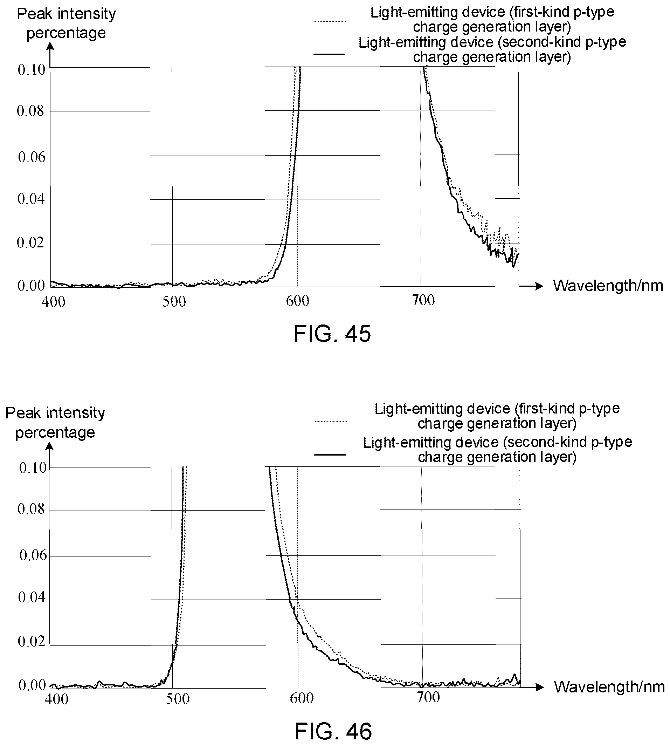

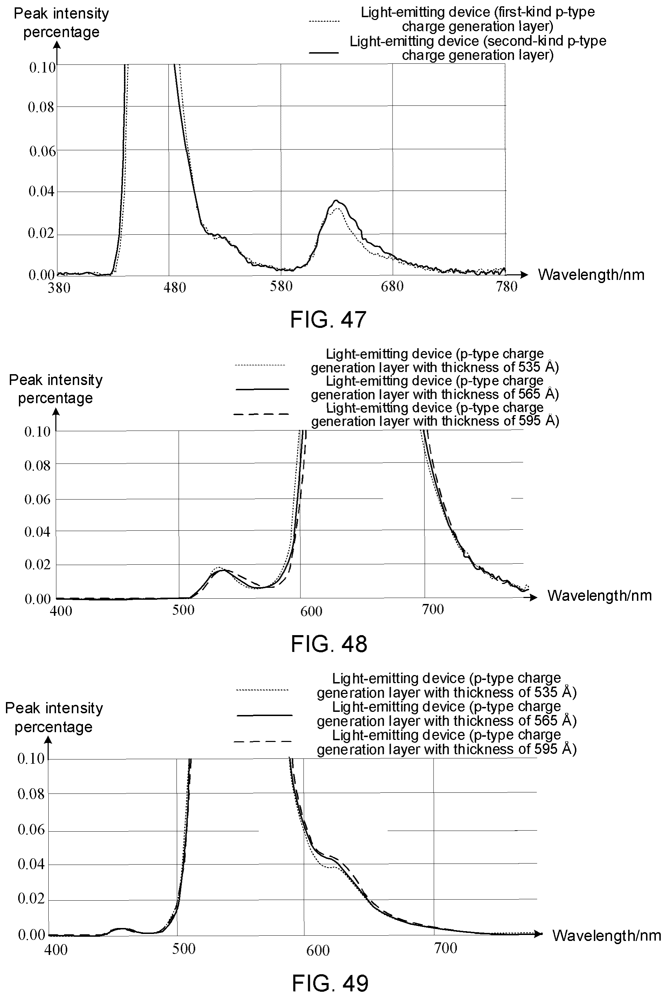

FIG. 45 is a spectrum diagram of a light-emitting device for emitting red light, in accordance with yet some other embodiments. FIG. 46 is a spectrum diagram of a light-emitting device for emitting green light, in accordance with yet some other embodiments. FIG. 47 is a spectrum diagram of a light-emitting device for emitting blue light, in accordance with yet some other embodiments.

FIGS. 45 to 47 each illustrate an example in which the grayscale of the light-emitting device O in the display substrate 100 is a low grayscale (e.g., 8-grayscale) and the n-type charge generation layer 31 is the first-kind n-type charge generation layer.

The color cast of the display substrate 100 in a low grayscale state is more obvious than the color cast of the display substrate 100 in a high grayscale state. Then, based on FIGS. 42 to 44, only the grayscale of the light-emitting device O was changed for experiments. Specifically, the grayscale of the light-emitting device O in the display substrate 100 as a low grayscale (e.g., 8-grayscale) is taken as an example for description.

In some embodiments, as shown in FIGS. 45 to 47, the proportion of undesired peaks of the light emitted by the light-emitting device O when the p-type charge generation layer 31 is the first-kind p-type charge generation layer is similar to the proportion of undesired peaks of the light emitted by the light-emitting device O when the p-type charge generation layer 31 is the second-kind p-type charge generation layer. That is, when the p-type charge generation layer 31 is the first-kind p-type charge generation layer or the second-kind p-type charge generation layer, there is no obvious difference in the proportion of undesired peaks of the light emitted by the light-emitting device O. Based on this, it can be known that in the low grayscale state, whether the p-type charge generation layer 31 is the first-kind p-type charge generation layer or the second-kind p-type charge generation layer has no significant difference in ameliorating the lateral crosstalk of the display substrate 100.

In summary, when the n-type charge generation layer 31 in the charge generation stack layer 30 may be the first-kind n-type charge generation layer, either the first-kind p-type charge generation layer or the second-kind p-type charge generation layer will be used. The first-kind p-type charge generation layer has a better effect in a high grayscale state than the second-kind p-type charge generation layer, but has non-obvious effect in a low grayscale state. Therefore, when the n-type charge generation layer 31 is the first-kind n-type charge generation layer, the second-kind p-type charge generation layer may be used to ameliorate the color cast of the display substrate 100.

With reference to Table 4 and FIGS. 42 to 47, it can be seen that, in the case where the n-type charge generation layer 31 is the first-kind n-type charge generation layer 31, whether the p-type charge generation layer is the first-kind p-type charge generation layer or the second-kind p-type charge generation layer, color coordinates at 255-grayscale and 8-grayscale have small difference, so that the effect of ameliorating the color cast of the display substrate 100 may be improved.

**Table 4 shows difference between color coordinates at 255-grayscale and 8-grayscale at different kinds of p-type charge generation layer**

| | Difference | |
|---|---|---|
| | First-kind p-type charge generation layer | Second-kind p-type charge generation layer |
| Light-emitting device O emitting red light | 0.001 | 0.002 |
| Light-emitting device O emitting green light | 0.003 | 0.004 |
| Light-emitting device O emitting blue light | 0.016 | 0.018 |

In the Table 4, for the light-emitting device O emitting red light and the light-emitting device O emitting green light, difference on the X-axis (X-coordinate in color coordinates) is determined. For the light-emitting device O emitting blue light, difference on the Y-axis (Y-coordinate in color coordinates) is determined.

In some embodiments, referring to FIG. 14, the thickness of the p-type charge generation layer 32 is in a range of 350 Å to 700 Å.

By setting the thickness of the p-type charge generation layer 32 in a range of 350 Å to 700 Å, the n-type charge generation layer 31, the p-type charge generation layer 32 and other film layers in the light-emitting device O may cooperate with each other to constitute a microcavity structure, so as to improve the light-emitting effect of the light-emitting device O.

In some examples, the thickness of the p-type charge generation layer 32 is in a range of 500 Å to 600 Å. By setting the thickness of the p-type charge generation layer 32 in a range of 500 Å to 600 Å, the n-type charge generation layer 31, the p-type charge generation layer 32 and other film layers in the light-emitting device O may cooperate with each other to constitute a microcavity structure, so as to improve the light-emitting effect of the light-emitting device O.

For example, the thickness of the p-type charge generation layer 32 is approximately any one of 350 Å, 400 Å, 450 Å, 500 Å, 550 Å, 600 Å, 650 Å, and 700 Å. However, the embodiments of the present disclosure are not limited thereto.

It will be noted that, considering an example in which the thickness of the p-type charge generation layer 32 is approximately 500 Å for introduction, due to certain uncontrollable errors (e.g., manufacturing process errors, equipment accuracy, measurement errors), in a case where the thickness of the p-type charge generation layer 32 fluctuates within a range of 10% × 500 Å, it may also be considered that the thickness of the p-type charge generation layer 32 satisfies the condition of being equal to 500 Å.

In addition, in some other examples, due to certain uncontrollable errors (e.g., manufacturing process errors, equipment accuracy, measurement errors), in a case where the thickness of the p-type charge generation layer 32 fluctuates within a range of 5% × 500 Å, it may also be considered that the thickness of the p-type charge generation layer 32 satisfies the condition of being equal to 500 Å.

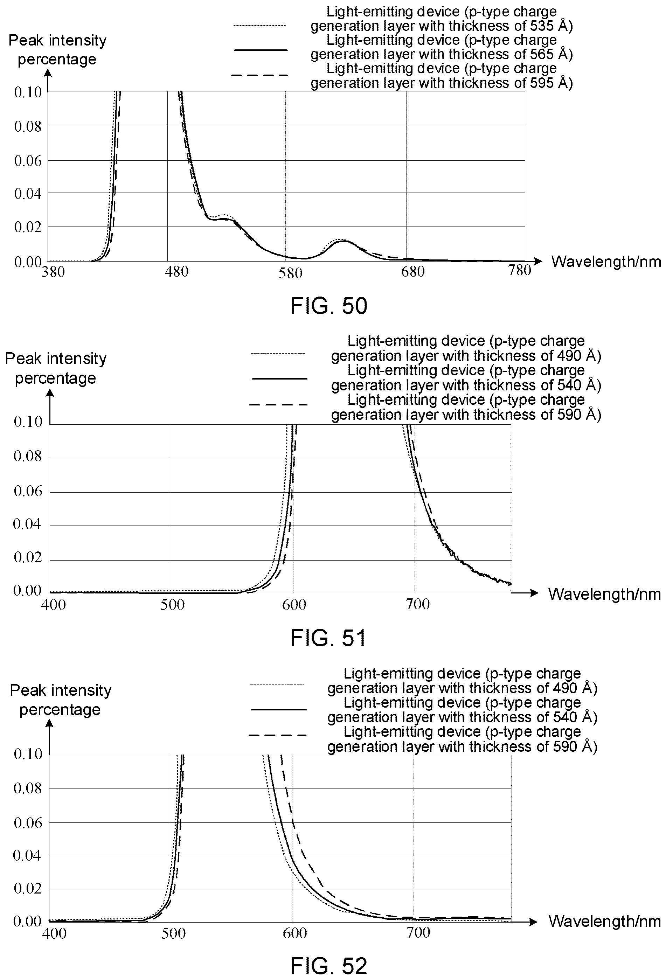

FIG. 48 is a spectrum diagram of a light-emitting device for emitting red light, in accordance with yet some other embodiments. FIG. 49 is a spectrum diagram of a light-emitting device for emitting green light, in accordance with yet some other embodiments. FIG. 50 is a spectrum diagram of a light-emitting device for emitting blue light, in accordance with yet some other embodiments. FIGS. 48 to 50 each illustrate an example in which the grayscale of the light-emitting device O in the display substrate 100 is a high grayscale (e.g., 255-grayscale) and the n-type charge generation layer 31 is the second-kind n-type charge generation layer.

The above embodiments verify that the thickness of the n-type charge generation layer 31 is helpful in reducing the undesired peaks of the light of the light-emitting device O. This embodiment verifies whether the thickness of the P-type charge generation layer is helpful in reducing the undesired peaks of the light of the light-emitting device O.

Based on this, in some embodiments, as shown in FIGS. 48 to 50, when the n-type charge generation layer 31 is the second-kind n-type charge generation layer, an experiment is conducted on the thickness of the P-type charge generation layer. Specifically, experiments were conducted on the thicknesses of the P-type charge generation layers being 535 Å, 565 Å, and 595 Å, respectively.

As shown in FIGS. 48 to 50, in the case where the n-type charge generation layer 31 is the second-kind n-type charge generation layer, the P-type charge generation layers with different thicknesses have no significant effect on reducing the undesired peaks of the light of the light-emitting device O. That is, the thickness of the P-type charge generation layer does not play a decisive role in ameliorating the color cast of the display substrate 100, and it may be specifically determined according to the requirements of the microcavity structure of the light-emitting device O.

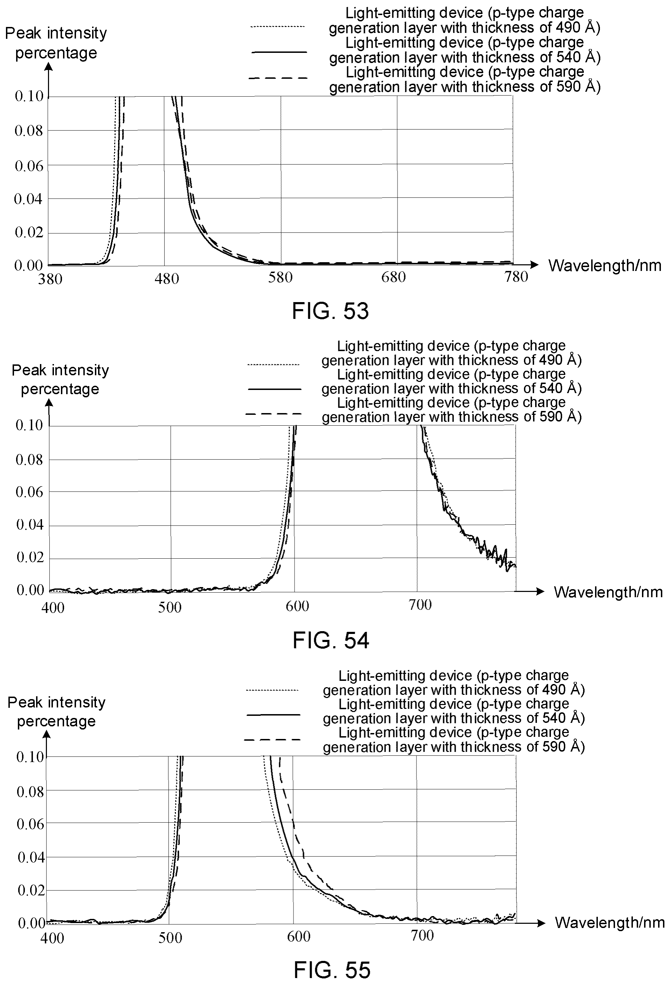

FIG. 51 is a spectrum diagram of a light-emitting device for emitting red light, in accordance with yet some other embodiments. FIG. 52 is a spectrum diagram of a light-emitting device for emitting green light, in accordance with yet some other embodiments. FIG. 53 is a spectrum diagram of a light-emitting device for emitting blue light, in accordance with yet some other embodiments. FIGS. 51 to 53 each illustrate an example in which the grayscale of the light-emitting device O in the display substrate 100 is a high grayscale (e.g., 255-grayscale) and the n-type charge generation layer 31 is the first-kind n-type charge generation layer.

In some embodiments, as shown in FIGS. 51 to 53, when the n-type charge generation layer 31 is the first-kind n-type charge generation layer, an experiment is conducted on the thickness of the P-type charge generation layer. Specifically, experiments were conducted on the thicknesses of the P-type charge generation layers being 490 Å, 540 Å, and 590 Å, respectively.

As shown in FIGS. 51 to 53, in the case where the n-type charge generation layer 31 is the first-kind n-type charge generation layer, the P-type charge generation layers with different thicknesses have no significant effect on reducing the undesired peaks of the light of the light-emitting device O. That is, the thickness of the P-type charge generation layer does not play a decisive role in ameliorating the color cast of the display substrate 100, and it may be specifically determined according to the requirements of the microcavity structure of the light-emitting device O.

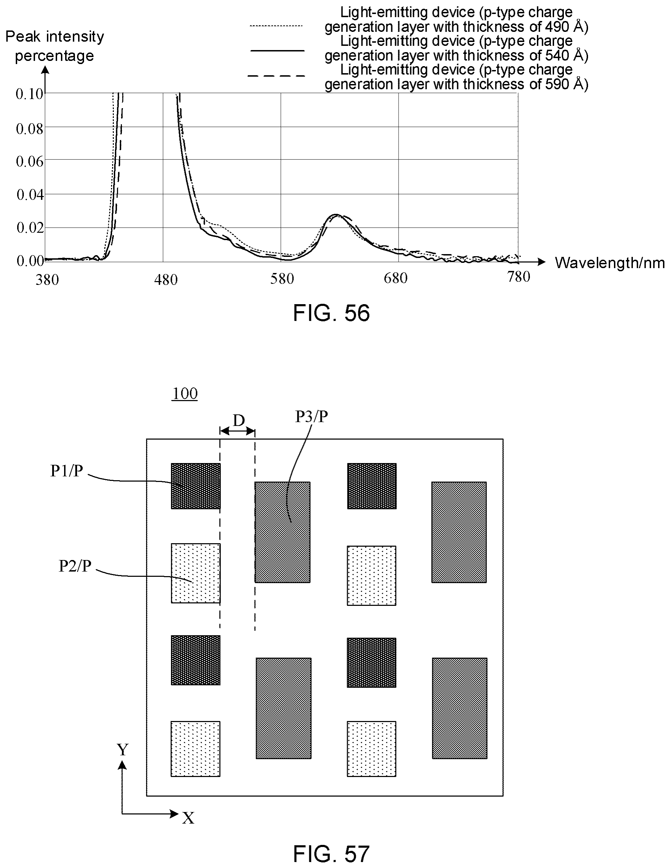

FIG. 54 is a spectrum diagram of a light-emitting device for emitting red light, in accordance with yet some other embodiments. FIG. 55 is a spectrum diagram of a light-emitting device for emitting green light, in accordance with yet some other embodiments. FIG. 56 is a spectrum diagram of a light-emitting device for emitting blue light, in accordance with yet some other embodiments. FIGS. 54 to 56 each illustrate an example in which the grayscale of the light-emitting device O in the display substrate 100 is a low grayscale (e.g., 8-grayscale) and the n-type charge generation layer 31 is the first-kind n-type charge generation layer.

The color cast of the display substrate 100 in a low grayscale state is more obvious than the color cast of the display substrate 100 in a high grayscale state. Then, based on FIGS. 51 to 53, only the grayscale of the light-emitting device O was changed for experiments. Specifically, the grayscale of the light-emitting device O in the display substrate 100 as a low grayscale (e.g., 8-grayscale) is taken as an example for description.

In some embodiments, as shown in FIGS. 54 to 56, when the n-type charge generation layer 31 is the first-kind n-type charge generation layer, an experiment is conducted on the thickness of the P-type charge generation layer. Specifically, experiments were conducted on the thicknesses of the P-type charge generation layers being 490 Å, 540 Å, and 590 Å, respectively.

As shown in FIGS. 51 to 53, in the case where the n-type charge generation layer 31 is the first-kind n-type charge generation layer, the P-type charge generation layers with different thicknesses have no significant effect on reducing the undesired peaks of the light of the light-emitting device O. That is, the thickness of the P-type charge generation layer does not play a decisive role in ameliorating the color cast of the display substrate 100, and it may be specifically determined according to the requirements of the microcavity structure of the light-emitting device O.

With reference to Table 5 and FIGS. 51 to 56, it can be seen that, in the case where the n-type charge generation layer 31 is the first-kind n-type charge generation layer 31, when the thickness of the P-type charge generation layer varies, color coordinates at 255-grayscale and 8-grayscale have small difference, which may be conducive to improving the effect of ameliorating the color cast of the display substrate 100.

For the light-emitting device O emitting red light and the light-emitting device O emitting green light, difference on the X-axis (X-coordinate in color coordinates) is determined. For the light-emitting device O emitting blue light, difference on the Y-axis (Y-coordinate in color coordinates) is determined.

**Table 5 shows difference between color coordinates at 255-grayscale and 8-grayscale at different thicknesses of p-type charge generation layer**

| | Difference | | |
|---|---|---|---|
| | The thickness of the p-type charge generation layer 31 is 490 Å | The thickness of the p-type charge generation layer 31 is 540 Å | The thickness of the p-type charge generation layer 31 is 590 Å |
| Light-emitting device O emitting red light | 0.000 | 0.001 | 0.001 |
| Light-emitting device O emitting green light | 0.004 | 0.003 | 0.002 |
| Light-emitting device O emitting blue light | 0.016 | 0.016 | 0.024 |

The above description introduces, with reference to related drawings, how to adjust various parameters of the charge generation stack layer 30 to reduce the proportion of undesired peaks of the light emitted by the light-emitting device O and ameliorate the color cast of the display substrate 100. The following description will introduce, from another perspective, how to reduce the proportion of undesired peaks of the light emitted by the light-emitting device O by adjusting a minimum distance between two adjacent sub-pixels P.

FIG. 57 is a structural diagram of a display substrate, in accordance with some other embodiments.

In some embodiments, as shown in FIG. 57, a minimum distance D between two adjacent sub-pixels P in the first direction X is greater than or equal to 19 µm.

Since the charge generation stack layers 30 between two adjacent sub-pixels P in the first direction X are connected, electrons and holes generated in a charge generation stack layer 30 are easily transported laterally to a charge generation stack layer 30 in an adjacent sub-pixel P, which leads to undesired peaks in the light emitted by the light-emitting device O.

In view of this, since the minimum distance D between two adjacent sub-pixels P in the first direction X is greater than or equal to 19 µm, a minimum distance between the charge generation stack layers 30 in the light-emitting devices O in the two adjacent sub-pixels P may be greater than or equal to 19 µm. Therefore, a path of the lateral transport of holes and electrons in the charge generation stack layer 30 is increased, and accordingly, the resistance to the lateral transport of holes and electrons in the charge generation stack layer 30 is also increased. Thus, it avoids that holes and electrons generated in a charge generation stack layer 30 of a light-emitting device O in one sub-pixel P among two adjacent sub-pixels P laterally move to a charge generation stack layer 30 of a light-emitting device O in another sub-pixel P among the two adjacent sub-pixels P, and in turn mitigates the lateral crosstalk.

In the case where the minimum distance D between two adjacent sub-pixels P in the first direction X is equal to or close to 19 µm, the minimum distance between the charge generation stack layers 30 in the light-emitting devices O in the two adjacent sub-pixels P may be large, that is, the path of the lateral transport of holes and electrons in the charge generation stack layer 30 is increased to mitigate the lateral crosstalk. In addition, it may also be possible to avoid the problem that the minimum distance between the two adjacent sub-pixels P is too large, which affects the pixel aperture ratio of the display substrate 100.

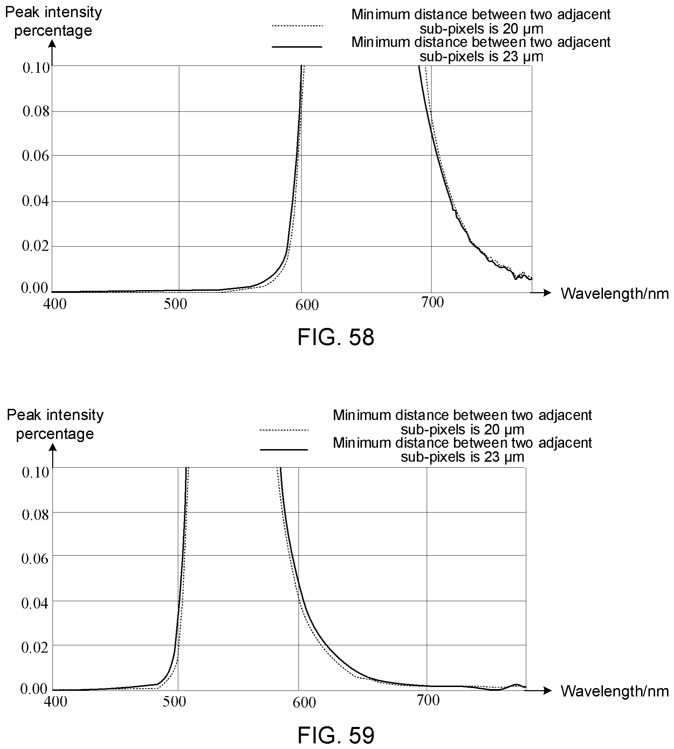

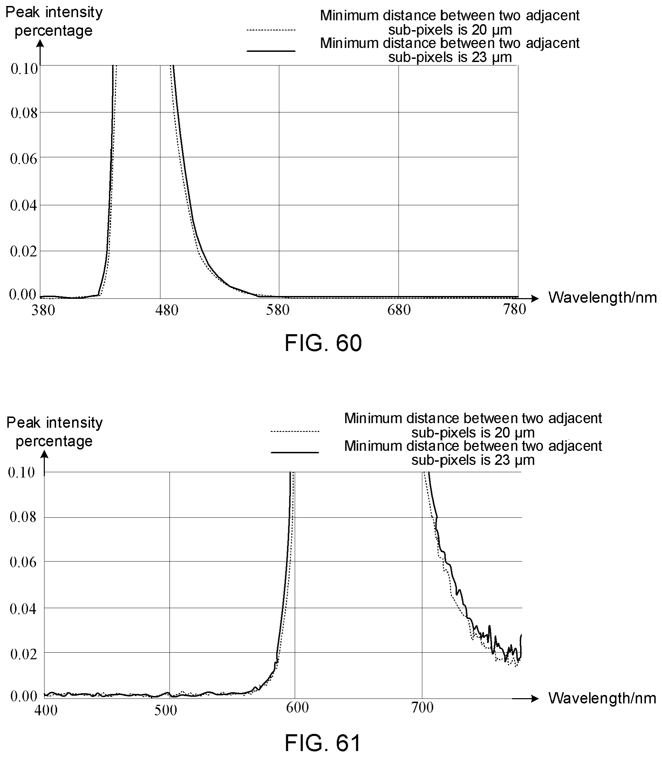

FIG. 58 is a spectrum diagram of a light-emitting device for emitting red light, in accordance with yet some other embodiments. FIG. 59 is a spectrum diagram of a light-emitting device for emitting green light, in accordance with yet some other embodiments. FIG. 60 is a spectrum diagram of a light-emitting device for emitting blue light, in accordance with yet some other embodiments. FIGS. 58 to 60 each illustrate an example in which the grayscale of the light-emitting device O in the display substrate 100 is a high grayscale (e.g., 255-grayscale).

In some embodiments, as shown in FIGS. 57 to 60, on the basis of keeping all parameters of the charge generation stack layer 30 unchanged, the minimum distance D between two adjacent sub-pixels P was adjusted for experiments. Specifically, a spectrum when the minimum distance D between two adjacent sub-pixels P is 20 µm and a spectrum when the minimum distance D between two adjacent sub-pixels P is 23 µm are illustrated.

As shown in FIGS. 58 to 60, in the case where the minimum distance D between two adjacent sub-pixels P is 23 µm, compared to the case where the minimum distance D between two adjacent sub-pixels P is 20 µm, the proportion of undesired peaks of the light emitted by the light-emitting device O may be smaller, which may be more conducive to ameliorating the color cast of the display substrate 100.

That is, on the basis of keeping all parameters of the charge generation stack layer 30 unchanged, in the case where the minimum distance D between two adjacent sub-pixels P in the first direction X is greater than or equal to 19 µm, the larger the minimum distance D between two adjacent sub-pixels P is, the smaller the proportion of undesired peaks of the light emitted by the light-emitting device O will be, which may be more conducive to ameliorating the color cast of the display substrate 100.

For example, considering a high grayscale (255-grayscale) as an example for introduction, as shown in FIG. 58, the proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%; as shown in FIG. 59, the proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%; as shown in FIG. 60, the proportion of undesired peaks generated by the light-emitting device O in the third sub-pixel P3 (blue) due to the impact of the light-emitting device O in the first sub-pixel P1 (red) and the light-emitting device O in the second sub-pixel P2 (green) is approximately 0%.

That is, among the light-emitting device O in the first sub-pixel P1 (red), the light-emitting device O in the second sub-pixel P2 (green) and the light-emitting device O in the third sub-pixel P3 (blue), the proportion of undesired peaks generated by a light-emitting device O in one sub-pixel P due to the impact of light-emitting devices O in the other two sub-pixels P is approximately 0%.

In summary, in the light-emitting device O emitting light of any color, in the case where the minimum distance D between two adjacent sub-pixels P is greater than or equal to 19 µm, the larger the minimum distance D between two adjacent sub-pixels P is, the smaller the proportion of undesired peaks of the light emitted by the light-emitting device O will be, which may be more conducive to ameliorating the color cast of the display substrate 100.

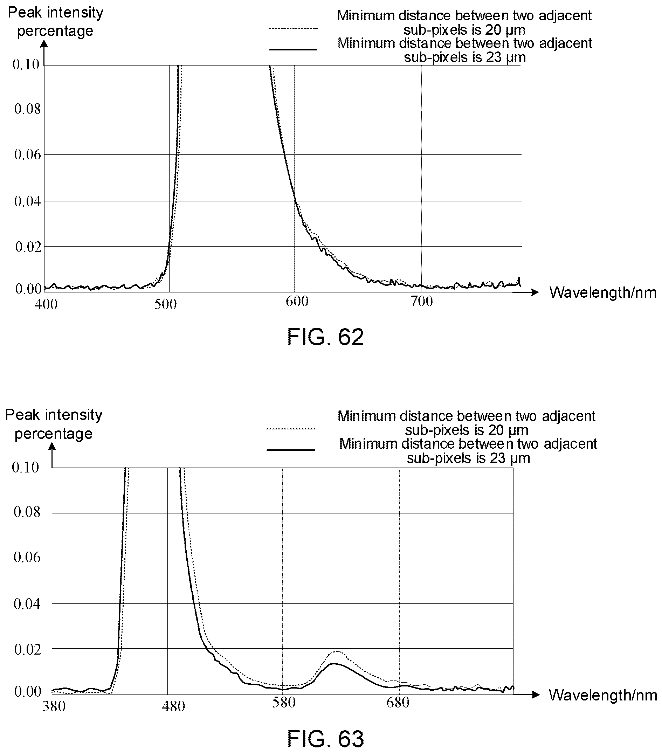

FIG. 61 is a spectrum diagram of a light-emitting device for emitting red light, in accordance with yet some other embodiments. FIG. 62 is a spectrum diagram of a light-emitting device for emitting green light, in accordance with yet some other embodiments. FIG. 63 is a spectrum diagram of a light-emitting device for emitting blue light, in accordance with yet some other embodiments. FIGS. 61 to 63 each illustrate an example in which the grayscale of the light-emitting device O in the display substrate 100 is a low grayscale (e.g., 8-grayscale).

The color cast of the display substrate 100 in a low grayscale state is more obvious than the color cast of the display substrate 100 in a high grayscale state. Then, based on FIGS. 58 to 60, only the grayscale of the light-emitting device O was changed for experiments. Specifically, the grayscale of the light-emitting device O in the display substrate 100 as a low grayscale (e.g., 8-grayscale) is taken as an example for description.

As shown in FIGS. 61 to 63, it can be seen that in the low grayscale state, in the case where the minimum distance D between two adjacent sub-pixels P is greater than or equal to 19 µm, the larger the minimum distance D between two adjacent sub-pixels P is, the smaller the proportion of undesired peaks of light emitted by the light-emitting device O will be; therefore, the color cast of the display substrate 100 may be ameliorated to a great extent.

Specifically, as shown in FIG. 61, the proportion of undesired peaks generated by the light-emitting device O in the first sub-pixel P1 (red) due to the impact of the light-emitting device O in the second sub-pixel P2 (green) and the light-emitting device O in the third sub-pixel P3 (blue) is approximately 0%.

As shown in FIG. 62, the proportion of undesired peaks generated by the light-emitting device O in the second sub-pixel P2 (green) due to the impact of the light-emitting device O in the first sub-pixel P1 (red) and the light-emitting device O in the third sub-pixel P3 (blue) is approximately 0%.

As shown in FIG. 63, the proportion of undesired peaks generated by the light-emitting device O in the third sub-pixel P3 (blue) due to the impact of the light-emitting device O in the first sub-pixel P1 (red) is less than or equal to 1.5%; and the proportion of undesired peaks generated by the light-emitting device O in the third sub-pixel P3 (blue) due to the impact of the light-emitting device O in the second sub-pixel P2 (green) is less than or equal to 1.5%.

In summary, in the low grayscale state, the undesired peaks of the light-emitting device O emitting red light and the light-emitting device O emitting green light are basically removed, and the light-emitting device O emitting blue light still has undesired peaks to a certain extent. However, the proportion of undesired peaks of the light emitted by the light-emitting device O emitting blue light may be made less than 4%, and the color cast of the display substrate 100 may be ameliorated.

In addition, in the light-emitting device O emitting light of any color, in the case where the minimum distance D between two adjacent sub-pixels P is greater than or equal to 19 µm, the larger the minimum distance D between two adjacent sub-pixels P is, the better the effect of ameliorating the color cast of the display substrate 100 will be.

With reference to Table 6 and FIGS. 58 to 63, it can be seen that, when the minimum distance D between two adjacent sub-pixels P varies, color coordinates at 255-grayscale and 8-grayscale have small difference, which may be conducive to improving the effect of ameliorating the color cast of the display substrate 100.

**Table 6 shows difference between color coordinates at 255-grayscale and 8-grayscale when the minimum distance D between two adjacent sub-pixels P varies**

| | Difference | |
|---|---|---|
| | Minimum distance D of 20 µm | Minimum distance D of 23 µm |
| Light-emitting device O emitting red light | 0.000 | 0.000 |
| Light-emitting device O emitting green light | 0.003 | 0.002 |
| Light-emitting device O emitting blue light | 0.011 | 0.008 |

For the light-emitting device O emitting red light and the light-emitting device O emitting green light, difference on the X-axis (X-coordinate in color coordinates) is determined. For the light-emitting device O emitting blue light, difference on the Y-axis (Y-coordinate in color coordinates) is determined.

In some embodiments, as shown in FIG. 42, the minimum distance D between two adjacent sub-pixels P in the first direction X is less than or equal to 24 µm. Therefore, it may avoid the problem that the minimum distance D between two adjacent sub-pixels P in the display substrate 100 is too large, which reduces the aperture ratio of the display substrate 100.

In the case where the minimum distance D between two adjacent sub-pixels P is equal to or close to 24 µm, the minimum distance D between two adjacent sub-pixels P may be relatively large, which effectively prevents the lateral movement of holes and electrons in the charge generation stack layer 30; in addition, it may also avoid the problem that the aperture ratio of the display substrate 100 is reduced due to the minimum distance D being too large.

In some embodiments, as shown in FIG. 57, the minimum distance D between two adjacent sub-pixels P in the first direction X is in a range of 19 µm to 24 µm.

In the case where the minimum distance D between two adjacent sub-pixels P is equal to or close to 19 µm, the minimum distance between the charge generation stack layers 30 in the light-emitting devices O in the two adjacent sub-pixels P may be large, that is, the path of the lateral transport of holes and electrons in the charge generation stack layer 30 is increased to mitigate the lateral crosstalk. In addition, it may also be possible to avoid the problem that the minimum distance between the two adjacent sub-pixels P is too large, which affects the pixel aperture ratio of the display substrate 100.

In the case where the minimum distance D between two adjacent sub-pixels P is equal to or close to 24 µm, the minimum distance D between two adjacent sub-pixels P may be relatively large, which effectively prevents the lateral movement of holes and electrons in the charge generation stack layer 30; in addition, it may also avoid the problem that the aperture ratio of the display substrate 100 is reduced due to the minimum distance D being too large.

In some examples, as shown in FIG. 57, the minimum distance D between two adjacent sub-pixels P in the first direction X is in a range of 20 µm to 23 µm.

For example, the minimum distance D between two adjacent sub-pixels P in the first direction X is approximately any one of 19 µm, 20 µm, 21 µm, 22 µm, 23 µm or 24 µm, which will not be limited in the embodiments of the present disclosure.

It will be noted that, considering an example in which the minimum distance D between two adjacent sub-pixels P is approximately 19 µm for introduction, due to certain uncontrollable errors (e.g., manufacturing process errors, equipment accuracy, measurement errors), in a case where the minimum distance D between two adjacent sub-pixels P fluctuates within a range of 10% × 19 µm, it may also be considered that the minimum distance D between two adjacent sub-pixels P satisfies the condition of being equal to 19 µm.

In addition, in some other examples, due to certain uncontrollable errors (e.g., manufacturing process errors, equipment accuracy, measurement errors), in a case where the minimum distance D between two adjacent sub-pixels P fluctuates within a range of 5% × 19 µm, it may also be considered that the minimum distance D between two adjacent sub-pixels P satisfies the condition of being equal to 19 µm.

In some embodiments, as shown in FIG. 57, the plurality of sub-pixels P include a plurality of first sub-pixels P1, a plurality of second sub-pixels P2 and a plurality of third sub-pixels P3. Colors of light emitted by the first sub-pixels P1, the second sub-pixels P2 and the third sub-pixels P3 are three primary colors. For example, the first sub-pixels P1 may emit red light, the second sub-pixels P2 may emit green light, and the third sub-pixels P3 may emit blue light. That is, the first sub-pixels P1 may be red sub-pixels, the second sub-pixels P2 may be green sub-pixels, and the third sub-pixels P3 may be blue sub-pixels. A size of the blue sub-pixel (the third sub-pixel P3) is greater than a size of any sub-pixel P among the plurality of first sub-pixels P1 and the plurality of second sub-pixels P2.

In some examples, the size of the blue sub-pixel (the third sub-pixel P3) is greater than a size of the red sub-pixel (the first sub-pixel P1).

In some examples, the size of the blue sub-pixel (the third sub-pixel P3) is greater than a size of the green sub-pixel (the second sub-pixel P2).

In some examples, the inventors have found through research that the brightness of the light-emitting device O in the blue sub-pixel (the third sub-pixel P3) is lower than the brightness of the light-emitting device O in any sub-pixel P of the red sub-pixel (the first sub-pixel P1) and the green sub-pixel (the second sub-pixel P2). Based on this, the size of the blue sub-pixel (the third sub-pixel P3) may be set greater than the size of the red sub-pixel (the first sub-pixel P1), and the size of the blue sub-pixel (the third sub-pixel P3) may be set greater than the size of the green sub-pixel (the second sub-pixel P2).

Therefore, the size of the blue sub-pixel (the third sub-pixel P3) may be increased to compensate for the low brightness of the light-emitting device O in the blue sub-pixel (the third sub-pixel P3), which is conducive to improving the display quality of the display substrate 100.

In some other examples, the sizes of the red sub-pixel (the first sub-pixel P1) and the green sub-pixel (the second sub-pixel P2) may be set according to the difference between the brightness of the red sub-pixel (the first sub-pixel P1) and the brightness of the green sub-pixel (the second sub-pixel P2). The embodiments of the present disclosure are not limited thereto.

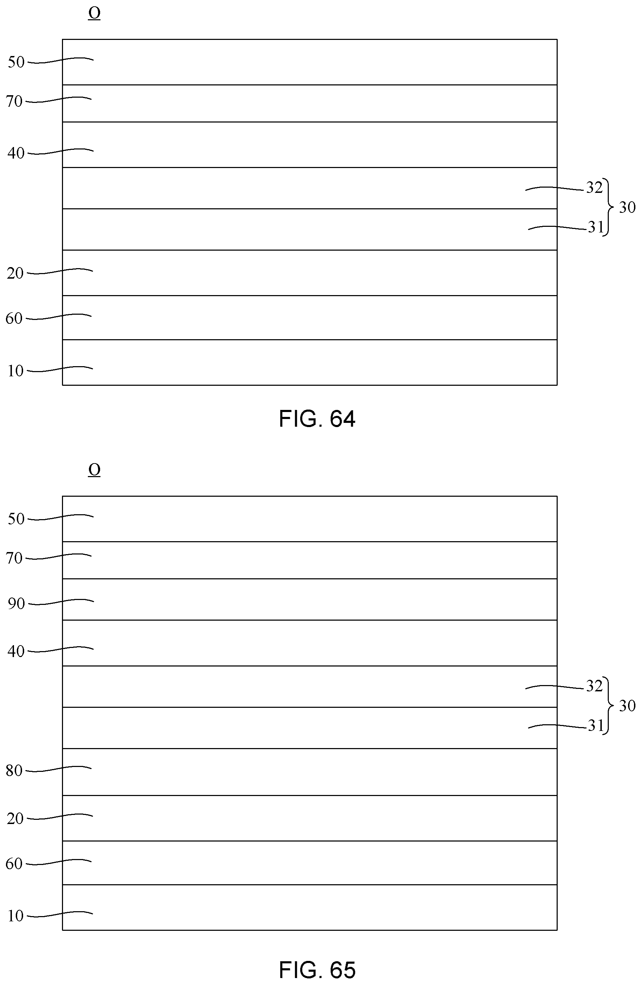

FIG. 64 is a structural diagram of a light-emitting device, in accordance with yet some other embodiments.

In some embodiments, referring to FIG. 64, the light-emitting device O further includes a hole transport layer (HTL) 60 and an electron transport layer (ETL) 70. The hole transport layer 60 is located between the first electrode 10 and the first light-emitting unit 20. The hole transport layer 60 may be used to improve the mobility of holes generated by the first electrode 10. The electron transport layer 70 is located between the second electrode 50 and the second light-emitting unit 40. The electron transport layer 70 may be used to improve the mobility of electrons generated by the second electrode.

Due to the hole transport layer 60 and the electron transport layer 70 in the light-emitting device O, the holes that are generated by the first electrode 10 and move toward the first light-emitting unit 20 and the electrons that are generated by the charge generation stack layer 30 and move toward the first light-emitting unit 20 may recombine into excitons in the first light-emitting unit 20 for light emission; and the electrons that are generated by the second electrode 50 and move toward the second light-emitting unit 40 and the holes that are generated by the charge generation stack layer 30 and move toward the second light-emitting unit 40 may recombine into excitons in the second light-emitting unit 40 for light emission.

In some other embodiments, the light-emitting device O further includes a hole injection layer (HIL) and an electron injection layer (EIL). The hole injection layer may be located between the first electrode 10 and the hole transport layer 60 to reduce a potential barrier between the first electrode 10 and the hole transport layer 60. The electron injection layer may be located between the second electrode 50 and the electron transport layer 70 to reduce a potential barrier between the second electrode 50 and the electron transport layer 70.

Based on this, after the first electrode 10 of the light-emitting device O receives a voltage and the second electrode 50 of the light-emitting device O receives a voltage, the first electrode 10 and the second electrode 50 create an electric field.

The first electrode 10 may generate positively charged holes due to the electric field, and the second electrode 50 may generate negatively charged electrons due to the electric field. In this case, the holes generated by the first electrode 10 may be injected into the hole transport layer 60 through the hole injection layer, and enter the first light-emitting unit 20 through the hole transport layer 60, and then may recombine with the electrons generated by the charge generation stack layer 30 in the first light-emitting unit 20 to develop excitons, and the excitons return to the ground state through radiation transition and emit photons.

Accordingly, the electrons generated by the second electrode 50 may be injected into the electron transport layer 70 through the electron injection layer, and enter the second light-emitting unit 40 through the electron transport layer 70, and then may recombine with the holes generated by the charge generation stack layer 30 in the second light-emitting unit 40 to develop excitons, and the excitons return to the ground state through radiation transition and emit photons. At this time, the light-emitting device O emits light.

FIG. 65 is a structural diagram of a light-emitting device, in accordance with yet some other embodiments.

In some embodiments, referring to FIG. 65, the light-emitting device O further includes a first hole blocking layer (HBL) 80 and a second hole blocking layer (HBL) 90. The first hole blocking layer 80 is located between the first light-emitting unit 20 and the charge generation stack layer 30. The second hole blocking layer 90 is located between the electron transport layer 70 and the second light-emitting unit 40.

When the holes generated by the first electrode 10 move to the first light-emitting unit 20, due to the electric field, the holes will continue to move to the charge generation stack layer 30, resulting in a decrease in the concentration of holes in the first light-emitting unit 20 and a reduction in the light-emitting effect. The first hole blocking layer 80 may prevent the holes from moving from the first light-emitting unit 20 to the charge generation stack layer 30.

Accordingly, when the holes generated by the charge generation stack layer 30 move to the second light-emitting unit 40, due to the electric field, the holes will continue to move to the second electrode 50, resulting in a decrease in the concentration of holes in the second light-emitting unit 40 and a reduction in the light-emitting effect. The second hole blocking layer 90 may prevent the holes from moving from the second light-emitting unit 40 to the second electrode 50.

In some other embodiments, the light-emitting device O further includes a first electron blocking layer (EBL) and a second electron blocking layer (EBL). The first electron blocking layer may be located between a first hole transport layer 60 and the first light-emitting unit 20. The second electron blocking layer may be located between the second light-emitting unit 40 and a second hole transport layer 70.

When the electrons generated by the charge generation stack layer 30 move to the first light-emitting unit 20, due to the electric field, the electrons will continue to move to the first electrode 10, resulting in a decrease in the concentration of electrons in the first light-emitting unit 20 and a reduction in the light-emitting effect. The first electron blocking layer may prevent the electrons from moving from the first light-emitting unit 20 to the first hole transport layer 60, that is, prevent the electrons from moving from the first light-emitting unit 20 to the first electrode 10.

Accordingly, when the electrons generated by the second electrode 50 move to the second light-emitting unit 40, due to the electric field, the electrons will continue to move to the charge generation stack layer 30, resulting in a decrease in the concentration of electrons in the second light-emitting unit 40 and a reduction in the light-emitting effect. The first electron blocking layer may prevent the electrons from moving from the second light-emitting unit 40 to the second hole transport layer 70, that is, prevent the electrons from moving from the second light-emitting unit 40 to the charge generation stack layer 30.

The foregoing descriptions are merely specific implementations of the present disclosure, but the protection scope of the present disclosure is not limited thereto, any changes or replacements that a person skilled in the art could conceive of within the technical scope of the present disclosure shall be included in the protection scope of the present disclosure. Therefore, the protection scope of the present disclosure should be determined by the protection scope of the claims.

## Claims

1. A display substrate, comprising
a plurality of sub-pixels arranged in a plurality of rows and a plurality of columns, wherein each sub-pixel includes a light-emitting device, and the light-emitting device includes a first electrode, a first light-emitting unit, a charge generation stack layer, a second light-emitting unit, and a second electrode that are stacked in sequence;
wherein light-emitting devices in two adjacent sub-pixels in a first direction emit light of different colors; and a proportion of undesired peaks in an emission peak in a luminescence spectrum corresponding to light emitted by a light-emitting device in at least part of the sub-pixels is less than or equal to 5%.

2. The display substrate according to claim 1, wherein in a case where a grayscale of the light-emitting device in the sub-pixel is higher than a threshold grayscale, the proportion of the undesired peaks in the emission peak in the luminescence spectrum corresponding to the light emitted by the light-emitting device in the at least part of the sub-pixels is approximately 0%;
in a case where the grayscale of the light-emitting device in the sub-pixel is lower than the threshold grayscale, the proportion of the undesired peaks in the emission peak in the luminescence spectrum corresponding to the light emitted by the light-emitting device in the at least part of the sub-pixels is less than or equal to 4%.

3. The display substrate according to claim 1 or 2, wherein a lateral resistance of the charge generation stack layer is greater than or equal to 100 GΩ/µm2.

4. The display substrate according to claim 3, wherein the lateral resistance of the charge generation stack layer is less than or equal to 260 GΩ/µm2.

5. The display substrate according to any one of claims 1 to 4, wherein the charge generation stack layer includes an n-type charge generation layer and a p-type charge generation layer; the p-type charge generation layer is located on a side of the n-type charge generation layer away from the first electrode;
the charge generation stack layer is configured such that the n-type charge generation layer transports electrons to the first light-emitting unit and the p-type charge generation layer transports holes to the second light-emitting unit.

6. The display substrate according to claim 5, wherein a minimum distance between a surface of the n-type charge generation layer close to the p-type charge generation layer and the first light-emitting unit is less than a minimum distance between a surface of the first electrode away from the first light-emitting unit and the first light-emitting unit.

7. The display substrate according to claim 6, wherein a thickness of the n-type charge generation layer is in a range of 50 Å to 250 Å.

8. The display substrate according to claim 7, wherein the thickness of the n-type charge generation layer is in a range of 50 Å to 70 Å.

9. The display substrate according to any one of claims 5 to 8, wherein the n-type charge generation layer is doped with a first foreign substance, and a doping concentration of the first foreign substance in the n-type charge generation layer is in a range of 0.5% to 2%.

10. The display substrate according to claim 9, wherein the p-type charge generation layer is doped with a second foreign substance, and a doping concentration of the second foreign substance in the p-type charge generation layer is in a range of 5% to 15%.

11. The display substrate according to claim 10, wherein in a case where the doping concentration of the first foreign substance in the n-type charge generation layer is in a range of 0.5% to 1%, the doping concentration of the second foreign substance in the p-type charge generation layer is in a range of 10% to 15%; or
in a case where the doping concentration of the first foreign substance in the n-type charge generation layer is in a range of 1% to 2%, the doping concentration of the second foreign substance in the p-type charge generation layer is in a range of 5% to 10%.

12. The display substrate according to any one of claims 5 to 11, wherein in a case where a lateral resistance of the charge generation stack layer is in a range of 180 GΩ/µm² to 260 GΩ/µm2, a doping concentration of a second foreign substance in the p-type charge generation layer is in a range of 5% to 10%; or
in a case where the lateral resistance of the charge generation stack layer is in a range of 100 GΩ/µm2 to 180 GΩ/µm2, the doping concentration of the second foreign substance in the p-type charge generation layer is in a range of 10% to 15%.

13. The display substrate according to any one of claims 1 to 12, wherein a minimum distance between the two adjacent sub-pixels in the first direction is greater than or equal to 19 µm.

14. The display substrate according to claim 13, wherein the minimum distance between the two adjacent sub-pixels in the first direction is less than or equal to 24 µm.

15. The display substrate according to any one of claims 5 to 14, wherein a thickness of the p-type charge generation layer is in a range of 350 Å to 700 Å.

16. The display substrate according to any one of claims 1 to 15, wherein the light-emitting device further includes:
a hole transport layer located between the first electrode and the first light-emitting unit; and
an electron transport layer located between the second electrode and the second light-emitting unit.

17. The display substrate according to claim 16, wherein the light-emitting device further includes:
a first hole blocking layer located between the first light-emitting unit and the charge generation stack layer; and
a second hole blocking layer located between the electron transport layer and the second light-emitting unit.

18. The display substrate according to any one of claims 1 to 17, wherein the plurality of sub-pixels include: a plurality of first sub-pixels, a plurality of second sub-pixels, and a plurality of third sub-pixels, which emit light of different colors;
the third sub-pixels are blue sub-pixels; and a size of a blue sub-pixel is greater than a size of any sub-pixel among the plurality of first sub-pixels and the plurality of second sub-pixels.

19. A display panel, comprising the display substrate according to any one of claims 1 to 18.
